# EUROPEAN PATENT SPECIFICATION

(11) **EP 1 724 294 B1**
(45) Date of publication and mention of the grant of the patent: **14.11.2012**
(21) Application number: 05719975.4
(22) Date of filing: 25.02.2005
(51) Int. Cl.: C08G 61/12, C09D 11/00, C09K 11/06, H05B 33/14

(54) **POLYMER AND POLYMERIC LUMINESCENT ELEMENT COMPRISING THE SAME**
POLYMER UND DIESES ENTHALTENDES POLYMER-LUMINESZENZELEMENT
POLYMERE ET ELEMENT POLYMERIC LUMINESCENT COMPRENANT CELUI-CI

(30) Priority: 26.02.2004 JP 2004051174; 26.02.2004 JP 2004051173
(43) Date of publication of application: 22.11.2006
(73) Proprietor: Sumitomo Chemical Company, Limited, Tokyo 104-8260 (JP)
(72) Inventor: AGATA, Katsumi, Chiba (JP); KITANO, Makoto, 1160 Auderghem (BE); TSUBATA, Yoshiaki 3050045, Ibaraki (JP); ANRYU, Makoto, Ibaraki (JP)
(74) Representative: Benson, John Everett
(86) International application number: PCT/JP2005/003703
(87) International publication number: WO 2005/082969

(56) References cited:
- EP-A- 1 394 188
- WO-A-99/54385
- WO-A1-02/26859
- GB-A- 2 427 612
- JP-A- 4 145 192
- JP-A- 10 310 635
- JP-A- 2001 265 034
- JP-A- 2002 080 570
- JP-A- 2004 162 059
- US-A1- 2008 233 429

## Description

### Technical Field

The present invention relates to a polymer compound and a polymer light emitting device (hereinafter, referred to as polymer LED in some cases) using this polymer compound.

### Background Art

Light emitting materials of high molecular weights are variously investigated since they are soluble in a solvent and can form a light emitting layer in a light emitting device by an application method, differing from those of low molecular weights, and for example, a polymer compound is disclosed which is a copolymer containing a repeating unit composed of a fluorene-diyl group and a repeating unit derived from an aromatic tertiary amine as shown in the following formula and of which aromatic ring at the end of a side chain is substituted with an alkyl group, as repeating units (International Publication WO99/54385, Japanese Patent Application National Publication (Laid-Open) No. 2002-539292).

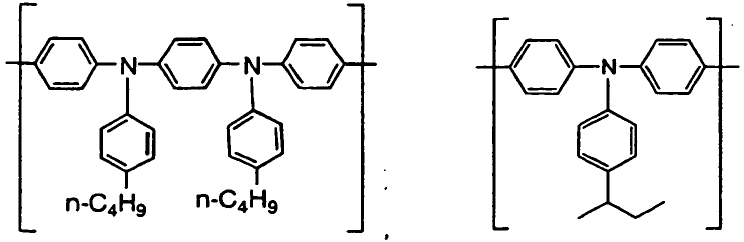

However, there has been a problem that when the above known polymer compound is used as a light emitting material of a light emitting device, the life of the light emitting device is not sufficient yet.

### DISCLOSURE OF THE INVENTION

The object of the present invention is to provide a polymer compound which produces a light emitting device of longer life when used as a light emitting material of a light emitting device.

The present inventors have intensively studied to solve the above problem and resultantly found that when a polymer compound which is a copolymer having a repeating unit derived from an aromatic tertiary amine and of which aromatic ring at the end of a side chain is substituted with a specific number of substituents and a repeating unit selected from the following formulae (2-1) and (2-2) is used as a light emitting material of a light emitting device, the life of the-light emitting device is improved, leading to completion of the present invention.

That is, the present invention provides a polymer compound capable of emitting light comprising at least one repeating unit of the following formula (1) and at least one repeating unit selected from the following formulae (2-1) and (2-2) and having a polystyrene-reduced number-average molecular weight of 10³ to 10⁸ as determined by a size exclusion chromatographic technique as defined herein: 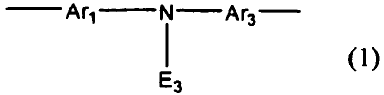 wherein, Ar₁ and Ar₃ represent each independently an arylene group or divalent heterocyclic group; E₃ represents a group of the following formula (3): 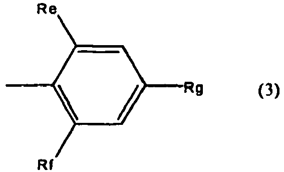 wherein, Re and Rf represent each independently an alkyl group having 3 or less carbon atoms, alkoxy group having 3 or less carbon atoms or alkylthio group having 3 or less carbon atoms and Rg represents an alkyl group having 3 to 20 carbon atoms, alkoxy group having 3 to 20 carbon atoms or alkylthio group having 3 to 20 carbon atoms; 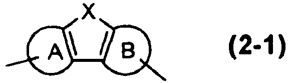 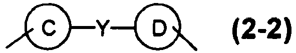 wherein, A ring, B ring, C ring and D ring represent each independently an aromatic ring; X represents -O-, -S-, -S (=O) -, -SO₂-, -C(R₁)(R₂)-, -B(R₃)-, -Si(R₄)(R₅)-, -P(R₆)-, -PR₇(=O)-, or -N(R₈)-; Y represents -CR₉=CR₁₀ or -C=C-; R₁, R₂, R₃, R₄, R₅, R₆, R₇ and R₈ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, silyloxy group, substituted silyloxy group, monovalent heterocyclic group or halogen atom; and R₉ and R₁₀ represent each independently a hydrogen atom, alkyl group, aryl group, monovalent heterocyclic group, carboxyl group, substituted carboxyl group or cyano group;
and wherein, if the ratio of the mol number of a repeating unit of said formula (1) to the sum of mol numbers of all repeating units in the polymer compound is represented by x and if the ratio of the sum of mol numbers of repeating units represented by said formulae (2-1) and (2-2) to the sum of mol numbers of all repeating units is represented by y, then, 0.01≤x+y≤1.
The present invention also provides:
a composition comprising at least one material selected from hole transporting materials, electron transporting materials and light emitting materials, and at least one polymer compound according to the present invention;
a solution comprising a polymer compound according to the present invention;
a light emitting film comprising a polymer compound according to the present invention;
an electrically conductive film comprising a polymer compound according to the present invention.
an organic semiconductor film comprising a polymer compound according to the present invention;
an organic transistor having an organic semiconductor film according to the present invention;
a method of forming a film according to the present invention, using an inkjet method;
a polymer light emitting device having a layer comprising a polymer compound according to the present invention between electrodes composed of an anode and a cathode;
a sheet light source comprising a polymer light emitting device according to the present invention;
a segment display comprising a polymer light emitting device according to the present invention;
a dot matrix display comprising a polymer light emitting device according to the present invention; and
a liquid crystal display using a polymer light emitting device according to the present invention as back light.

### BEST MODES FOR CARRYING OUT THE INVENTION

In the above formula (1), Ar₁, Ar₂, Ar₃ and Ar₄ represent each independently an arylene group or divalent heterocyclic group.

Here, the arylene group is an atomic group obtained by removing two hydrogen atoms from an aromatic hydrocarbon, and includes also those having a benzene ring or condensed ring, and those obtained by bonding two or more independent benzene rings or condensed rings directly or via a vinylene group and the like. The arylene group may have a substituent. Examples of the substituent include alkyl groups, alkoxy groups, alkylthio groups, aryl groups, aryloxy groups, arylthio groups, arylakyl groups, arylalkoxy groups, arylalkylthio groups, arylalkenyl groups, arylalkynyl groups, amino group, substituted amino groups, silyl group, substituted silyl groups, silyloxy group, substituted silyloxy groups, halogen atoms, acyl group, acyloxy group, imine residue, amide group, acid imide group, monovalent heterocyclic groups, carboxyl group, substituted carboxyl groups, cyano group and the like, and preferable are alkyl groups, alkoxy groups, alkylthio groups, aryl groups, aryloxy groups, arylthio groups, substituted amino groups, substituted silyl groups, substituted silyloxy groups and monovalent heterocyclic groups.

The carbon number of a portion an arylene group excepting substituents is usually about 6 to 60, and preferably 6 to 20. The total carbon number including substituents of an arylene group is usually about 6 to 100.

Examples of the arylene group include phenylene groups (e.g., following formulae 1 to 3), naphthalene-diyl groups (following formulae 4 to 13), anthracene-diyl groups (following formulae 14 to 19), biphenyl-diyl groups (following formulae 20 to 25), terphenyl-diyl groups (following formulae 26 to 28), condensed ring compound groups (following formulae 29 to 35), fluorene-diyl groups (following formulae 36 to 38), indenofluorene-diyl groups (following formulae 38A to 38D), stilbene-diyl groups (following formulae A to D), distilbene-diyl groups (following formulae E and F), and the like. Of them, phenylene groups, biphenyl-diyl groups, fluorene-diyl groups and stilbene-diyl groups are preferable.

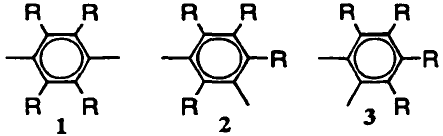

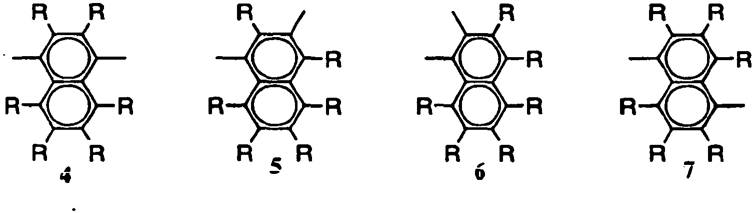

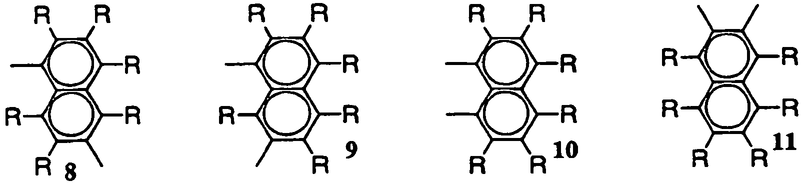

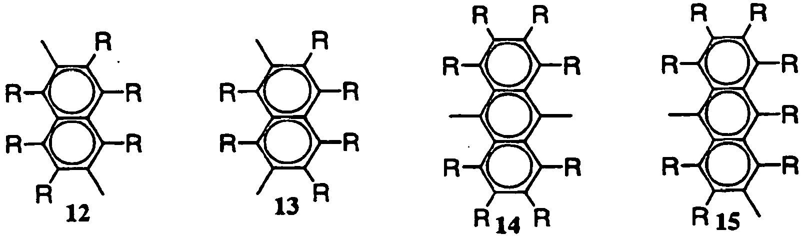

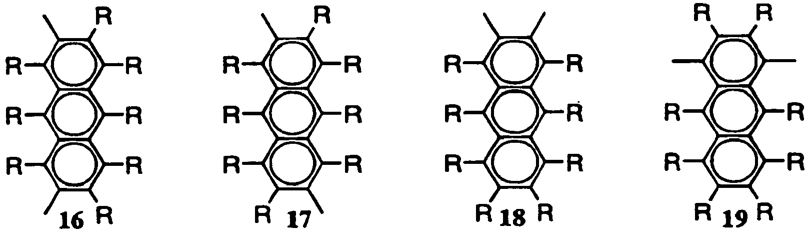

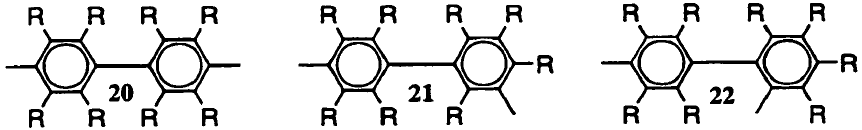

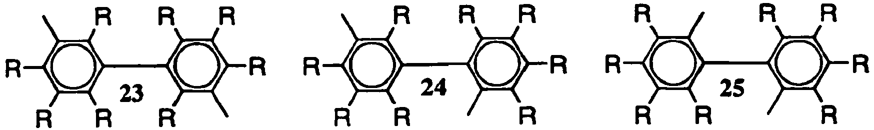

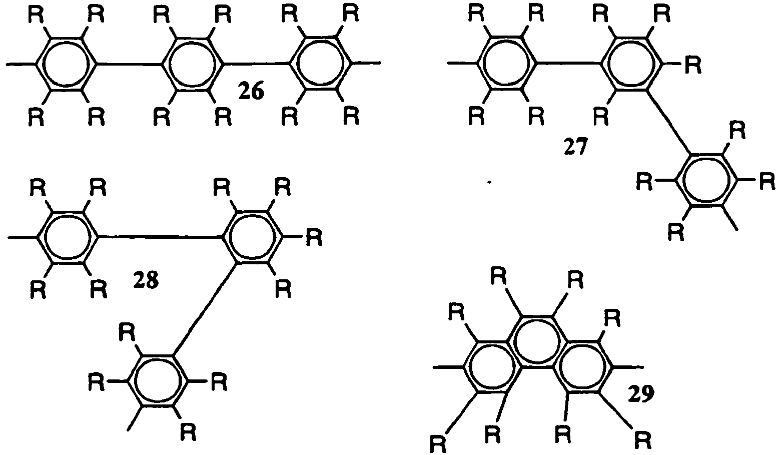

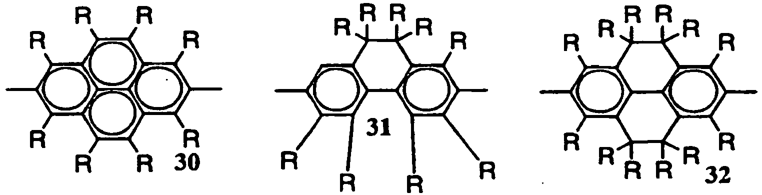

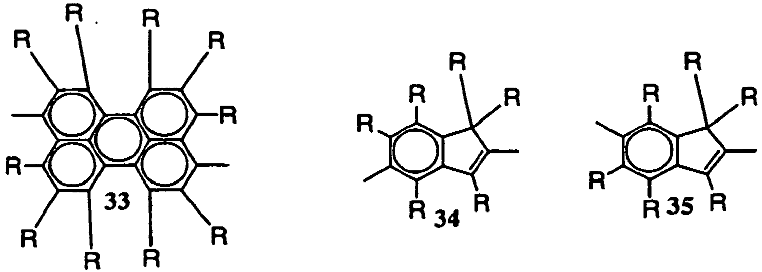

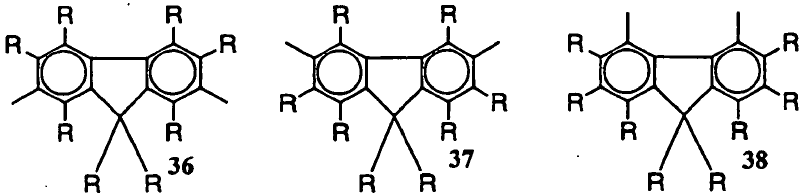

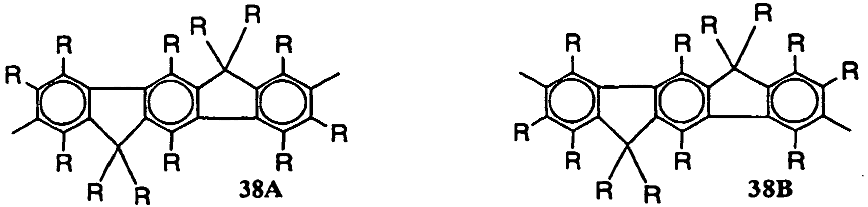

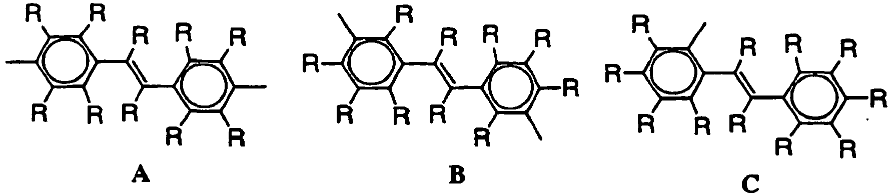

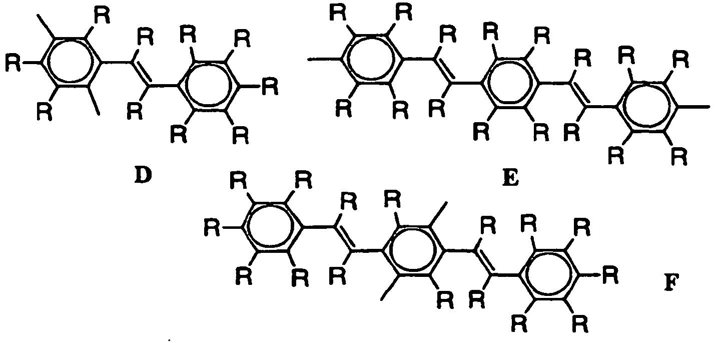

In the present invention, the divalent heterocyclic group means a remaining atomic group obtained by removing two hydrogen atoms from a heterocyclic compound, and may have a substituent.

Here, the heterocyclic compound includes organic compounds having a cyclic structure in which elements constituting the ring include not only a carbon atom but also hetero atoms such as oxygen, sulfur, nitrogen, phosphorus, boron, arsenic and the like contained in the ring. Of divalent heterocyclic groups, divalent aromatic heterocyclic groups are preferable.

The substituent includes alkyl groups, alkoxy groups, alkylthio groups, aryl groups, aryloxy groups, arylthio groups, arylakyl groups, arylalkoxy groups, arylalkylthio groups, arylalkenyl groups, arylalkynyl groups, amino group, substituted amino groups, silyl group, substituted silyl groups, silyloxy group, substituted silyloxy groups, halogen atoms, acyl group, acyloxy group, imino group, amide group, acid imide group, monovalent heterocyclic groups, carboxyl group, substituted carboxyl groups, cyano group and the like, and preferable are alkyl groups, alkoxy groups, alkylthio groups, aryl groups, aryloxy groups, arylthio groups, substituted amino groups, substituted silyl groups, substituted silyloxy groups and monovalent heterocyclic groups.

The carbon number of a portion of a divalent heterocyclic group excepting substituents is usually about 3 to 60. The total carbon number including substituents of a divalent heterocyclic group is usually about 3 to 100.

Examples of the divalent heterocyclic group include the following groups.

Divalent heterocyclic group including nitrogen as a hetero atom; pyridine-diyl groups (following formulae 39 to 44), diazaphenylene groups (following formulae 45 to 48), quinoline-diyl groups (following formulae 49 to 63), quinoxaline-diyl groups (following formulae 64 to 68), acridine-diyl groups (following formulae 69 to 72), bipyridyl-diyl groups (following formulae 73 to 75), phenanethroline-diyl groups (following formulae 76 to 78), and the like.

Groups containing silicon, nitrogen, oxygen, sulfur, selenium, boron and the like as a hetero atom and having a fluorene structure (following formulae 79 to 93, G to I).

Groups containing silicon, nitrogen, oxygen, sulfur, selenium, boron and the like as a hetero atom and having an indenofluorene structure (following formulae J to O).

5-membered ring heterocyclic groups containing silicon, nitrogen, oxygen, sulfur, selenium and the like as a hetero atom (following formulae 94 to 98).

5-membered ring condensed heterocyclic groups containing silicon, nitrogen, oxygen, sulfur, selenium and the like as a hetero atom (following formulae 99 to 110).

5-membered ring heterocyclic groups containing silicon, nitrogen, oxygen, sulfur, selenium and the like as a hetero atom and bonding at a-position of its hetero atom to form a dimer or oligomer (following formulae 111 to 112).

5-membered ring heterocyclic groups containing silicon, nitrogen, oxygen, sulfur, selenium and the like as a hetero atom and bonding at a-position of its hetero atom to a phenyl group (following formulae 113 to 119).

5-membered ring condensed heterocyclic groups containing oxygen, nitrogen, oxygen, sulfur and the like as a hetero atom and substituted by a phenyl group, furyl group or thienyl group (following formulae 120 to 125).

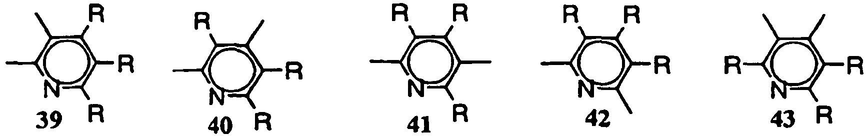

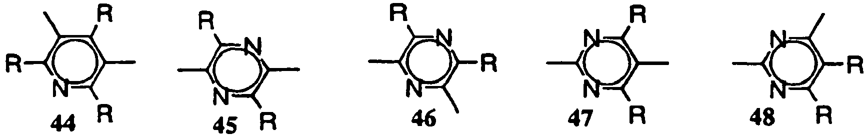

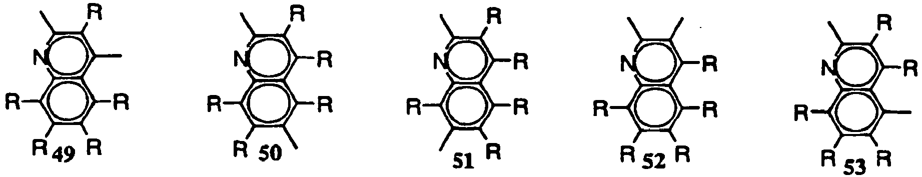

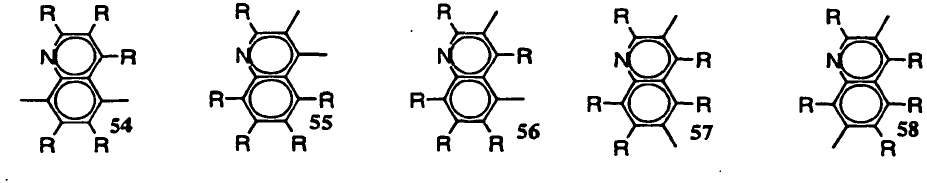

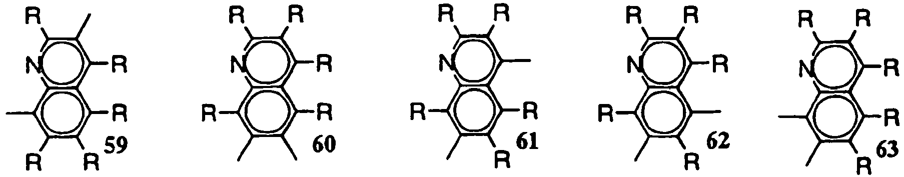

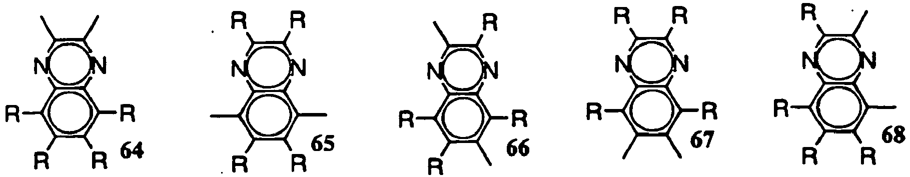

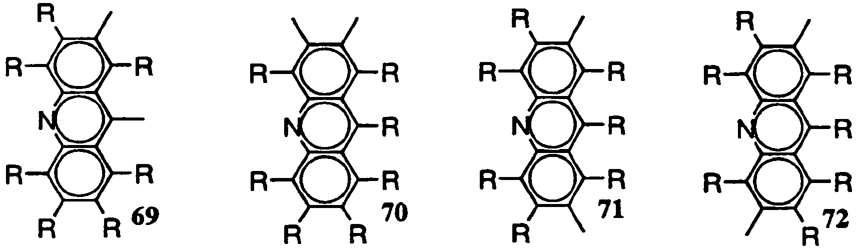

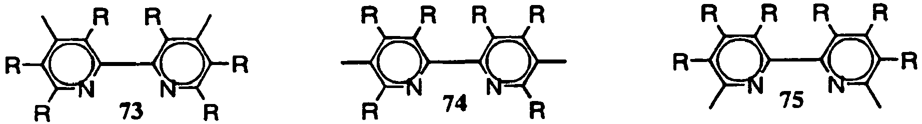

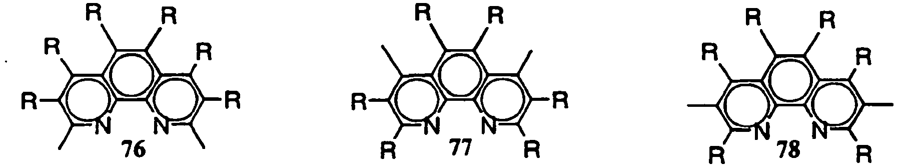

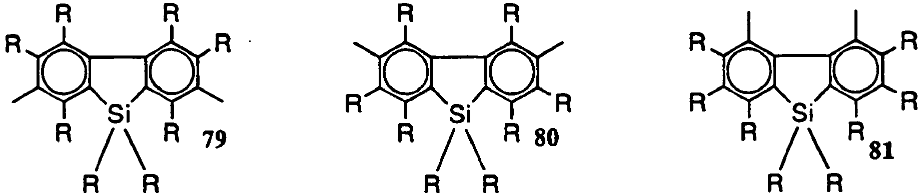

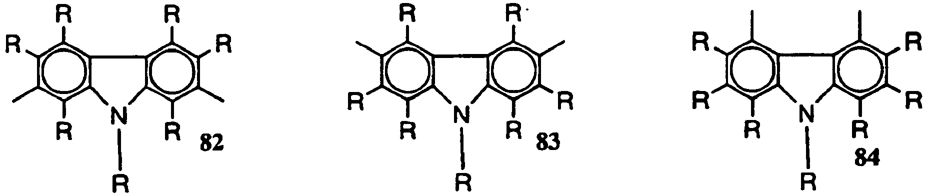

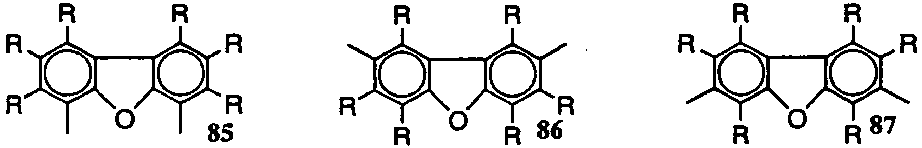

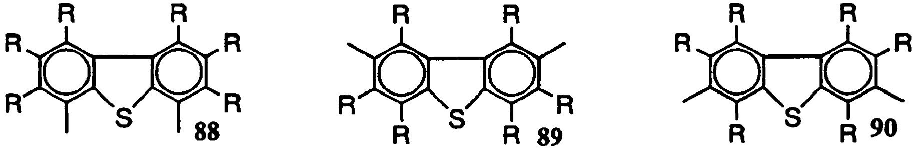

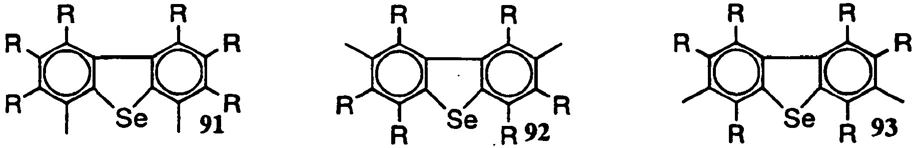

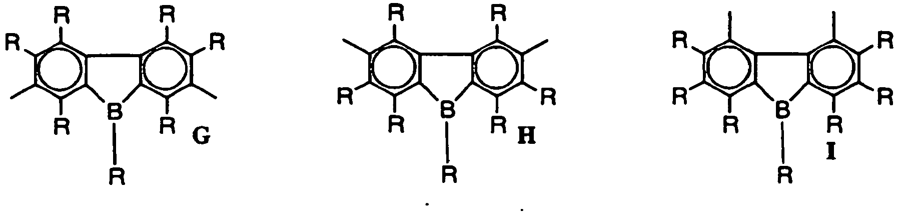

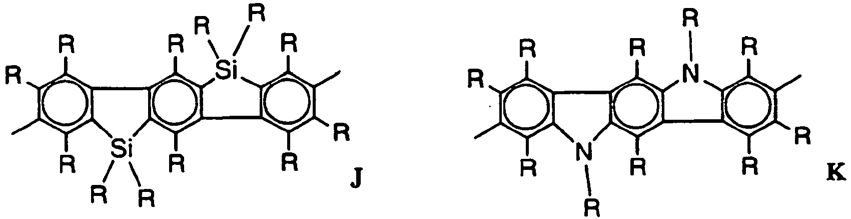

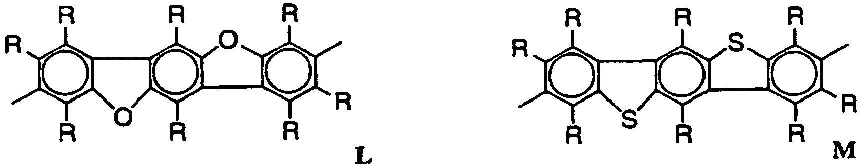

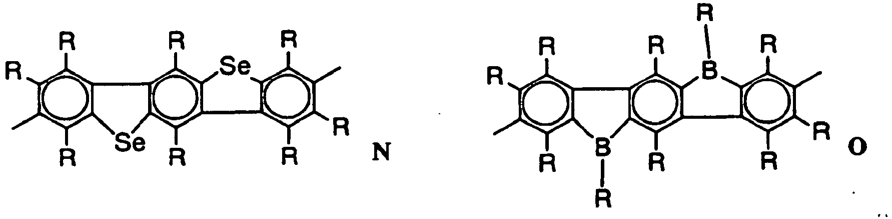

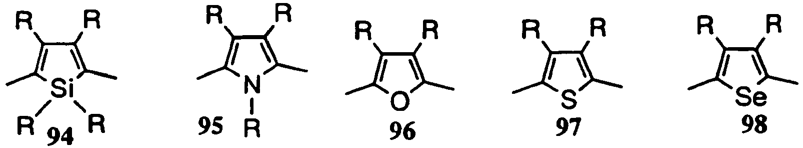

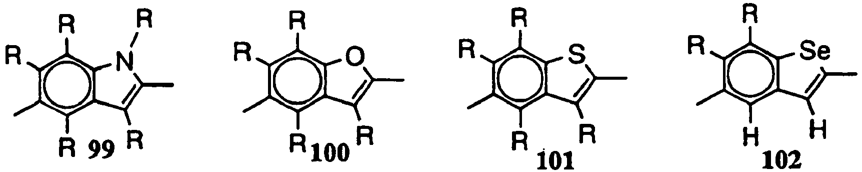

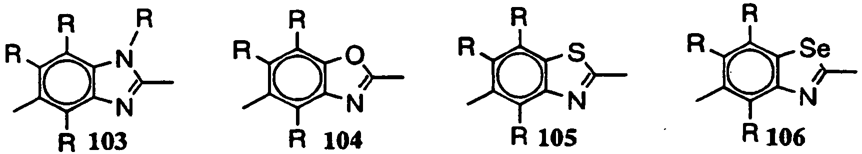

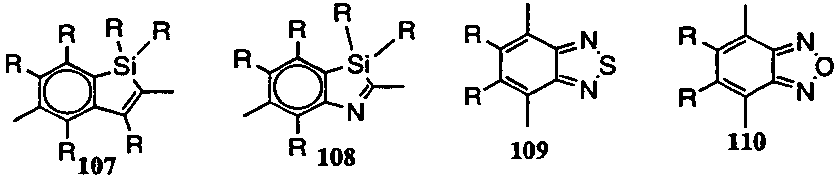

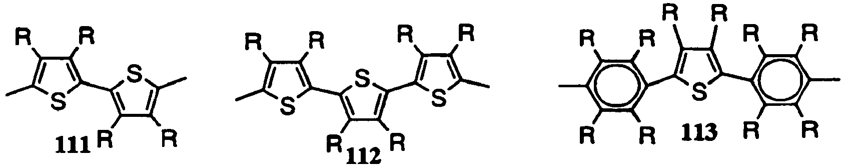

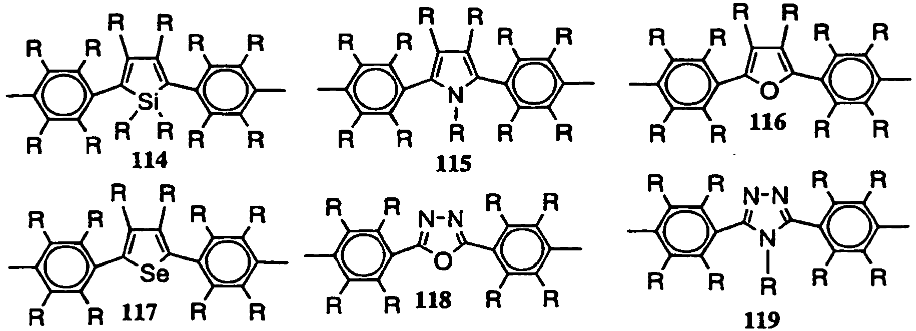

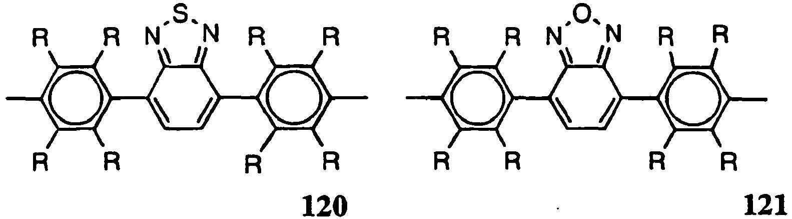

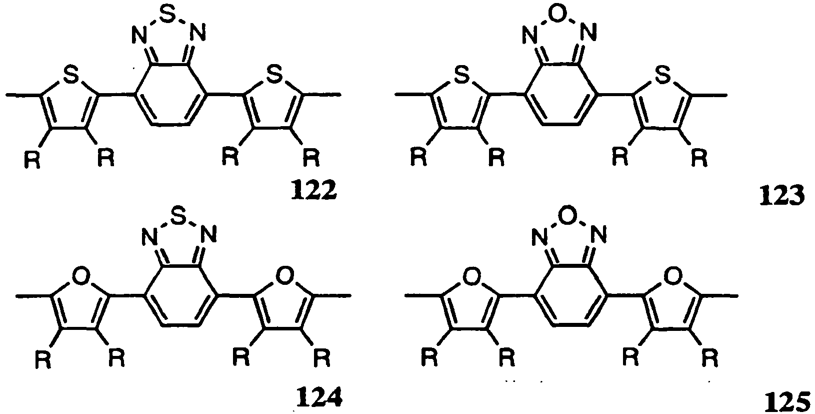

In the above formulae 1 to 125, 38A and 38B and A to O, Rs represent each independently a hydrogen atom, alkyl group, alkoxy group, alkylthio group, aryl group, aryloxy group, arylthio group, arylakyl group, arylalkoxy group, arylalkylthio group, arylalkenyl group, arylalkynyl group, amino group, substituted amino group, silyl group, substituted silyl group, silyloxy group, substituted silyloxy group, halogen atom, acyl group, acyloxy group, imino group, amide group, imide group, monovalent heterocyclic group, carboxyl group, substituted carboxyl group or cyano group.

Here, the alkyl group may be linear, branched or cyclic, and usually has about 1 to 20 carbon atoms, and specific examples thereof include a methyl group, ethyl group, propyl group, i-propyl group, butyl group, i-butyl group, t-butyl group, pentyl group, hexyl group, cyclohexyl group, heptyl group, octyl group, 2-ethylhexyl group, nonyl group, decyl group, 3,7-dimethyloctyl group, lauryl group, trifluoromethyl group, pentafluoroethyl group, perfluorobutyl group, perfluorohexyl group, perfluorooctyl group and the like, and preferable are a pentyl group, hexyl group, octyl group, 2-ethylhexyl group, decyl group and 3,7-dimethyloctyl group.

The alkoxy group may be linear, branched or cyclic, and usually has about 1 to 20 carbon atoms, and specific examples thereof include a methoxy group, ethoxy group, propyloxy group, i-propyloxy group, butoxy group, i-butoxy group, t-butoxy group, pentyloxy group, hexyloxy group, cyclohexyloxy group, heptyloxy group, octyloxy group, 2-ethylhexyloxy group, nonyloxy group, decyloxy group, 3,7-dimethyloctyloxy group, lauryloxy group, trifluoromethoxy group, pentafluoroethoxy group, perfluorobutoxy group, perfluorohexyl group, perfluorooctyloxy group, methoxymethyloxy group, 2-methoxyethyloxy group and the like, and preferable are a pentyloxy group, hexyloxy group, octyloxy group, 2-ethylhexyloxy group, decyloxy group and 3,7-dimethyloctyloxy group.

The alkylthio group may be linear, branched or cyclic, and usually has about 1 to 20 carbon atoms, and specific examples thereof include a methylthio group, ethylthio group, propyl this group, i-propylthio group, butylthio group, i-butylthio group, t-butylthio group, pentylthio group, hexylthio group, cyclohexylthio group, heptylthio group, octylthio group, 2-ethylhexylthio group, nonylthio group, decylthio group, 3,7-dimethyloctylthio group, laurylthio group, trifluoromethylthio group and the like, and preferable are a pentylthio group, hexylthio group, octylthio group, 2-ethylhexylthio group, decylthio group and 3,7-dimethyloctylthio group.

The aryl group usually has about 6 to 60 carbon atoms, and specific examples thereof include a phenyl group, C₁ to C₁₂ alkoxyphenyl groups (C₁ to C₁₂ means 1 to 12 carbon atoms, applicable also in the following descriptions), C₁ to C₁₂ alkylphenyl groups, 1-naphthyl group, 2-naphthyl group, 1-anthracenyl group, 2-anthracenyl group, 9-anthracenyl group, pentafluorophenyl group and the like, and preferable are C₁ to C₁₂ alkoxyphenyl groups and C₁ to C₁₂ alkylphenyl groups. Here, the aryl group is an atomic group obtained by removing one hydrogen atom from an aromatic hydrocarbon. The aromatic hydrocarbon include those having a benzene ring or condensed ring, and those obtained by bonding two or more independent benzene rings or condensed rings directly or via a vinylene group and the like.

Specific examples of the C₁ to C₁₂ alkoxy include methoxy, ethoxy, propyloxy, i-propyloxy, butoxy, i-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, lauryloxy group and the like.

Specific examples of the C₁ to C₁₂ alkyl include methyl, ethyl, propyl, i-propyl, butyl, i-butyl, t-butyl, pentyl, hexyl, cyclohexyl, heptyl, octyl, 2-ethylhexyl, nonyl, decyl, 3,7-dimethyloctyl, lauryl and the like.

The aryloxy group usually has about 6 to 60 carbon atoms, and specific examples thereof include a phenoxy group, C₁ to C₁₂ alkoxyphenoxy groups, C₁ to C₁₂ alkylphenoxy groups, 1-naphthyloxy group, 2-naphthyloxy group, pentafluorophenyloxy group and the like, and preferable are C₁ to C₁₂ alkoxyphenoxy groups and C₁ to C₁₂ alkylphenoxy groups.

The arylthio group usually has about 6 to 60 carbon atoms, and specific examples thereof include a phenylthio group, C₁ to C₁₂ alkoxyphenylthio groups, C₁ to C₁₂ alkylphenylthio groups, 1-naphthylthio group, 2-naphthylthio group, pentafluorophenylthio group and the like, and preferable are C₁ to C₁₂ alkoxyphenylthio groups and C₁ to C₁₂ alkylphenylthio groups.

The arylalkyl group usually has about 7 to 60 carbon atoms, and specific examples thereof include phenyl-C₁ to C₁₂ alkyl groups such as a phenylmethyl group, phenylethyl group, phenylbutyl group, phenylpentyl group, phenylhexyl group, phenylheptyl group, phenyloctyl group and the like, C₁ to C₁₂ alkoxyphenyl-C₁ to C₁₂ alkyl groups, C₁ to C₁₂ alkylphenyl-C₁ to C₁₂ alkyl groups, 1-naphthyl-C₁ to C₁₂ alkyl groups, 2-naphthyl-C₁ to C₁₂ alkyl groups and the like, and preferable are C₁ to C₁₂ alkoxyphenyl-C₁ to C₁₂ alkyl groups and C₁ to C₁₂ alkylphenyl-C₁ to C₁₂ alkyl groups.

The arylalkoxy group usually has about 7 to 60 carbon atoms, and specific examples thereof include phenyl-C₁ to C₁₂ alkoxy groups such as a phenylmethoxy group, phenylethoxy group, phenylbutoxy group, phenylpentyloxy group, phenylhexyloxy group, phenylheptyloxy group, phenyloctyloxy group and the like, C₁ to C₁₂ alkoxyphenyl-C₁ to C₁₂ alkoxy groups, C₁ to C₁₂ alkylphenyl-C₁ to C₁₂ alkoxy groups, 1-naphthyl-C₁ to C₁₂ alkoxy groups, 2-naphthyl-C₁ to C₁₂ alkoxy groups and the like, and preferable are C₁ to C₁₂ alkoxyphenyl-C₁ to C₁₂ alkoxy groups and C₁ to C₁₂ alkylphenyl-C₁ to C₁₂ alkoxy groups.

The arylalkylthio group usually has about 7 to 60 carbon atoms, and specific examples thereof include phenyl-C₁ to C₁₂ alkylthio groups, C₁ to C₁₂ alkoxyphenyl-C₁ to C₁₂ alkylthio groups, C₁ to C₁₂ alkylphenyl-C₁ to C₁₂ alkylthio groups, 1-naphthyl-C₁ to C₁₂ alkylthio groups, 2-naphthyl-C₁ to C₁₂ alkylthio groups and the like, and preferable are C₁ to C₁₂ alkoxyphenyl-C₁ to C₁₂ alkylthio groups and C₁ to C₁₂ alkylphenyl-C₁ to C₁₂ alkylthio groups.

The arylalkynyl group usually has about 8 to 60 carbon atoms, and specific examples thereof include phenyl-C₁ to C₁₂ alkenyl groups, C₁ to C₁₂ alkoxyphenyl-C₁ to C₁₂ alkenyl groups , C₁ to C₁₂ alkylphenyl-C₁ to C₁₂ alkenyl groups, 1-naphthyl-C₁ to C₁₂ alkenyl groups, 2-naphthyl-C₁ to C₁₂ alkenyl groups and the like, and preferable are C₁ to C₁₂ alkoxyphenyl-C₁ to C₁₂ alkenyl groups and C₁ to C₁₂ alkylphenyl-C₁ to C₁₂ alkenyl groups.

The arylalkynyl group usually has about 8 to 60 carbon atoms, and specific examples thereof include phenyl-C₂ to C₁₂ alkynyl groups, C₁ to C₁₂ alkoxyphenyl-C₂ to C₁₂ alkynyl groups , C₁ to C₁₂ alkylphenyl-C₂ to C₁₂ alkynyl groups , 1-naphthyl-C₂ to C₁₂ alkynyl groups, 2-naphthyl-C₂ to C₁₂ alkynyl groups and the like, and preferable are C₁ to C₁₂ alkoxyphenyl-C₂ to C₁₂ alkynyl groups and C₁ to C₁₂ alkylphenyl-C₂ to C₁₂ alkynyl groups.

The substituted amino group includes amino groups substituted with one or two groups selected from alkyl groups, aryl groups, arylakyl groups or monovalent heterocyclic groups, and has about 1 to 60 carbon atoms. Specific examples of the substituted amino group include a methylamino group, dimethylamino group, ethylamino group, diethylamino group, propylamino group, dipropylamino group, i-propylamino group, diisopropylamino group, butylamino group, i-butyamino group, t-butylamino group, pentylamino group, hexylamino group, cyclohexylamino group, heptylamino group, octylamino group, 2-ethylhexylamino group, nonylamino group, decylamino group, 3,7-dimethyloctylamino group, laurylamino group, cyclopentylamino group, dicyclopentylamino group, cyclohexylamino group, dicyclohexylamino group, pyrrolidyl group, piperidyl group, ditrifluoromethylamino group, phenylamino group, diphenylamino group, C₁ to C₁₂ alkoxyphenylamino groups, di(C₁ to C₁₂ alkoxyphenyl)amino groups, di(C₁ to C₁₂ alkylphenyl)amino groups, 1-naphthylamino group, 2-naphthylamino group, pentafluorophenylamino group, pyridylamino group, pyridazinylamino group, pyrimidylamino group, pyrazylamino group, triazylamino group, phenyl C₁ to C₁₂ alkylamino groups, C₁ to C₁₂ alkoxyphenyl-C₁ to C₁₂ alkylamino groups , C₁ to C₁₂ alkylphenyl-C₁ to C₁₂ alkylamino groups, di(C₁ to C₁₂ alkoxyphenyl-C₁ to C₁₂ alkyl)amino groups, di(C₁ to C₁₂ alkylphenyl-C₁ to C₁₂ alkyl)amino groups, 1-naphthyl-C₁ to C₁₂ alkylamino groups, 2-naphthyl-C₁ to C₁₂ alkylamino groups, carbazoyl group and the like.

The substituted silyl group includes silyl groups substituted with one, two or three groups selected from alkyl groups, aryl groups, arylakyl groups and monovalent heterocyclic groups, and has about 1 to 60 carbon atoms.

Specific examples of the substituted silyl group include a trimethylsilyl group, triethylsilyl group, tripropylsilyl group, tri-i-propylsilyl group, dimethyl-i-propylsilyl group, diethyl-i-propylsilyl group, t-butylsilyldimethylsilyl group, pentyldimethylsilyl group, hexyldimethylsilyl group, heptyldimethylsilyl group, octyldimethylsilyl group, 2-ethylhexyl-dimethylsilyl group, nonyldimethylsilyl group, decyldimethylsilyl group, 3,7-dimethyloctyl-dimethylsilyl group, lauryldimethylsilyl group, phenyl-C₁ to C₁₂ alkylsilyl groups, C₁ to C₁₂ alkoxyphenyl-C₁ to C₁₂ alkylsilyl groups, C₁ to C₁₂ alkylphenyl-C₁ to C₁₂ alkylsilyl groups, 1-naphthyl-C₁ to C₁₂ alkylsilyl groups, 2-naphthyl-C₁ to C₁₂ alkylsilyl groups, phenyl-C₁ to C₁₂ alkyldimethylsilyl groups, triphenylsilyl group, tri-p-xylylsilyl group, tribenzylsilyl group, diphenylmethylsilyl group, t-butyldiphenylsilyl group, dimethylphenylsilyl group, trimethoxysilyl group, triethoxysilyl group, tripropyloxysilyl group, tri-i-propylsilyl group, dimethyl-i-propylsilyl group, methyldimethoxysilyl group, ethyldimethoxysilyl group, and the like.

The substituted silyloxy group includes silyloxy groups substituted with one, two or three groups selected from alkyl groups, aryl groups, arylakyl groups and monovalent heterocyclic groups, and usually has about 1 to 60 carbon atoms.

Specific examples of the substituted silyloxy group include a trimethylsilyloxy group, triethylsilyloxy group, tripropylsilyloxy group, tri-i-propylsilyloxy group, dimethyl-i-propylsilyloxy group, diethyl-i-propylsilyloxy group, t-butyldimethylsilyloxy group, pentyldimethylsilyloxy group, hexyldimethylsilyloxy group, heptyldimethylsilyloxy group, octyldimethylsilyloxy group, 2-ethylhexyl-dimethylsilyloxy group, nonyldimethylsilyloxy group, decyldimethylsilyloxy group, 3,7-dimethyloctyl-dimethylsilyloxy group, lauryldimethylsilyloxy group, phenyl-C₁ to C₁₂ alkylsilyloxy groups, C₁ to C₁₂ alkoxyphenyl-C₁ to C₁₂ alkylsilyloxy groups, C₁ to C₁₂ alkylphenyl-C₁ to C₁₂ alkylsilyloxy groups, 1-naphthyl-C₁ to C₁₂ alkylsilyloxy groups, 2-naphthyl-C₁ to C₁₂ alkylsilyloxy groups, phenyl-C₁ to C₁₂ alkyldimethylsilyloxy groups, triphenylsilyloxy group, tri-p-xylylsilyloxy group, tribenzylsilyloxy group, diphenylmethylsilyloxy group, t-butyldiphenylsilyloxy group, dimethylphenylsilyloxy group, trimethoxysilyloxy group, triethoxysilyloxy group, tripropyloxysilyloxy group, tri-i-propylsilyloxy group, dimethyl-i-propylsilyloxy group, methyldimethoxysilyloxy group, ethyldimethoxysilyloxy group, and the like.

Examples of the halogen atom includes a fluorine atom, chlorine atom, bromine atom and iodine atom.

The acyl group usually has about 2 to 20 carbon atoms, and specific examples thereof include an acetyl group, propionyl group, butylyl group, isobutylyl group, pivaloyl group, benzoyl group, trifluoroacetyl group, pentafluorobenzoyl group and the like.

The acyloxy group usually has about 2 to 20 carbon atoms, and specific examples thereof include an acetoxy group, propionyloxy group, butylyloxy group, isobutylyloxy group, pivaloyloxy group, benzoyloxy group, trifluoroacetyloxy group, pentafluorobenzoyloxy group and the like.

The imine residue includes residues obtained by removing one hydrogen atom from imine compounds (meaning an organic compound having -N=C- in the molecule. Examples thereof include aldimine, ketimine and, compounds obtained by substituting a hydrogen atom on N of these compounds with an alkyl group or the like), and has about 2 to 20 carbon atoms, and specific examples thereof include the following groups and the like.

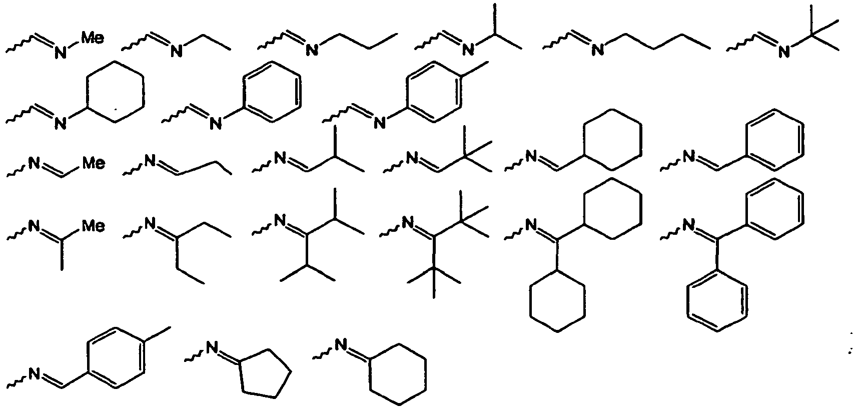

The amide group usually has about 1 to 20 carbon atoms, and specific examples thereof include a formamide group, acetamide group, propioamide group, butyloamide group, benzamide group, trifluoroacetamide group, pentafluorobenzamide group, diformamide group, diacetamide group, dipropioamide group, dibutyloamide group, dibenzamide group, ditrifluoroacetamide group, dipentafluorobenzmide group and the like.

The acid imide group includes residues obtained by removing a hydrogen atom bonded to a nitrogen atom from an acid imide, has about 4 to 20 carbon atoms, and specific examples thereof include the following groups and the like.

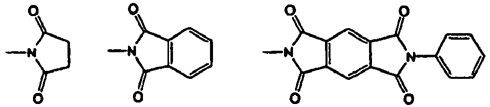

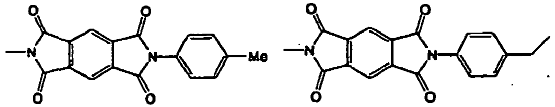

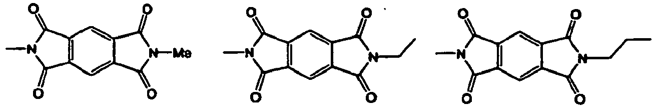

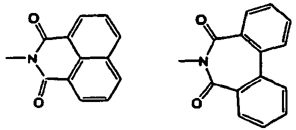

In the above examples, Me represents a methyl group.

The monovalent heterocyclic group means a remaining atomic group obtained by removing one hydrogen atom from a heterocyclic compound, and this group may have a substituent.

The un-substituted monovalent heterocyclic group usually has about 4 to 60 carbon atoms, preferably 4 to 20 carbon atoms.

Examples of the monovalent heterocyclic group include a thienyl group, C₁ to C₁₂ alkylthienyl groups, pyrrolyl group, furyl group, pyridyl group, C₁ to C₁₂ alkylpyridyl groups and the like, and preferable are a thienyl group, C₁ to C₁₂ alkylthienyl groups, pyridyl group and C₁ to C₁₂ alkylpyridyl groups.

The substituted carboxyl group includes carboxyl groups substituted with an alkyl group, aryl group, arylakyl group or monovalent heterocyclic group, and usually has about 2 to 60 carbon atoms, and specific examples thereof include a methoxycarbonyl group, ethoxycarbonyl group, propoxycarbonyl group, i-propoxycarbonyl group, butoxycarbonyl group, i-butoxycarbonyl group, t-butoxyarbonyl group, pentyloxy carbonyl group, hexyloxycarbonyl group, cyclohexyloxycarbonyl group, heptyloxycarbonyl group, octyloxycarbonyl group, 2-ethylhexyloxycarbonyl group, nonyloxycarbonyl group, decyloxycarbonyl group, 3,7-dimethyloctyloxycarbonyl group, dodecyloxycarbonyl group, trifluoromethoxycarbonyl group, pentafluoroethoxycarbonyl group, perfluorobutoxycarbonyl group, perfluorohexyloxycarbonyl group, perfluorooctyloxycarbonyl group, phenoxycarbonyl group, naphthoxycarbonyl group, pyridyloxycarbonyl group, and the like.

In the above examples, a plurality of Rs are present in one structural formula, and these may be the same or different. For enhancing solubility in a solvent, it is preferable that at least one of a plurality of Rs in one structural formula is a group other than a hydrogen atom, and it is preferable that the form of a repeating unit including substituents shows little symmetry. Further, it is preferable that at least one R in one structural formula is a group containing a cyclic or branched alkyl group. A plurality of Rs may also be connected to form a ring.

When R is a substituent containing an alkyl group in the above formula, this alkyl group may be linear, branched or cyclic, or a combination thereof , and in the case of not linear chain, exemplified are an isoamyl group, 2-ethylhexyl group, 3,7-dimethyloctyl group, cyclohexyl group, 4-C₁ to C₁₂ alkylcyclohexyl group and the like. Further, a methyl group or methylene group in the group containing an alkyl group may be substituted by a methyl group or methylene group substituted with a hetero atom or one or more fluorine atoms. Exemplified as these hetero atoms are an oxygen atom, sulfur atom, nitrogen atom and the like.

In the above formula (1), Ar₁, Ar₂, Ar₃ and Ar₄ preferably represent an arylene group, more preferably represent a substituted or un-substituted phenylene group, substituted or un-substituted biphenyldiyl group, substituted or un-substituted fluorene-diyl group, or substituted or un-substituted stilbene-diyl group as shown below, further preferably an un-substituted phenylene group.

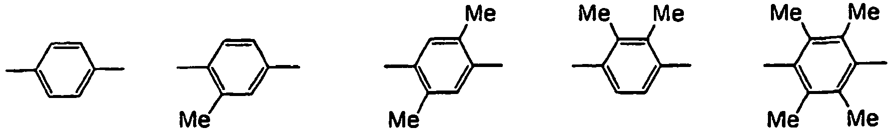

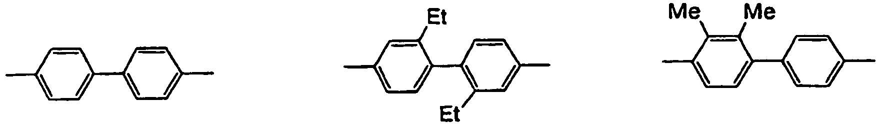

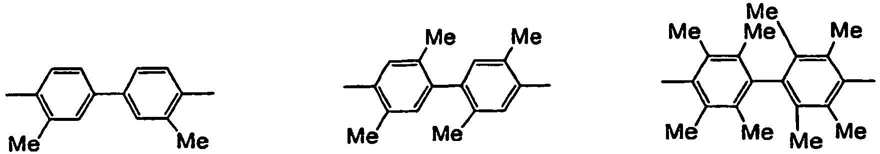

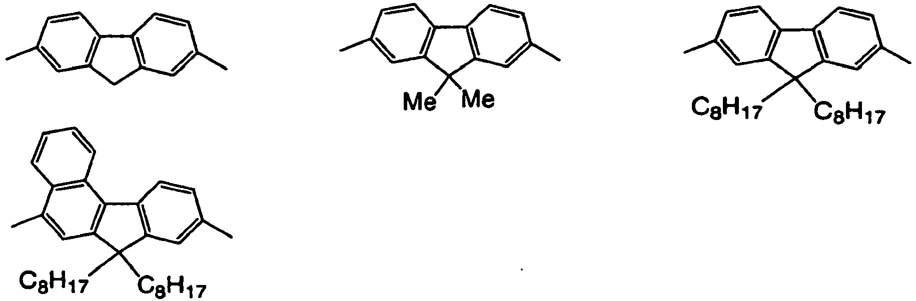

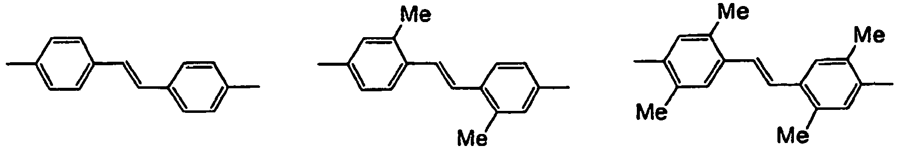

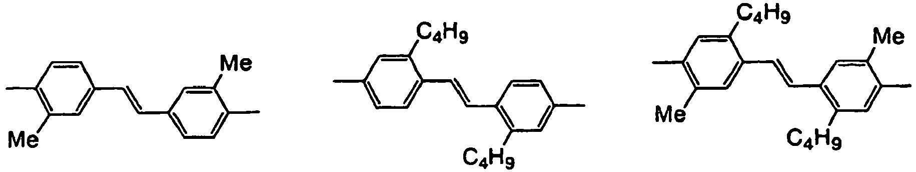

In the above formula (1), represents a group of the following formula (3).

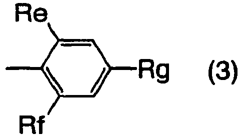

In the formula, Re, Rf and Rg represent each independently an alkyl group having 3 or less carbon atoms, an alkoxy group having 3 or less carbon atoms or an alkylthio group having 3 or less carbon atoms and Rg represents an alkyl group having 3 to 20 carbon atoms, an alkoxy group having 3 to 20 carbon atoms or an alkylthio group having 3 to 20 carbon atoms.

Specific examples of a repeating unit of the above formula (1) in which Ar₁ and Ar₃ represent each independently an un-substituted phenylene group include the followings.

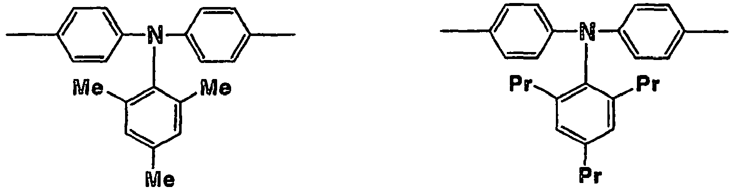

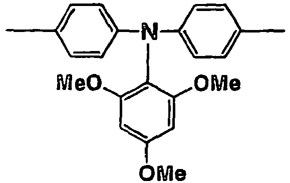

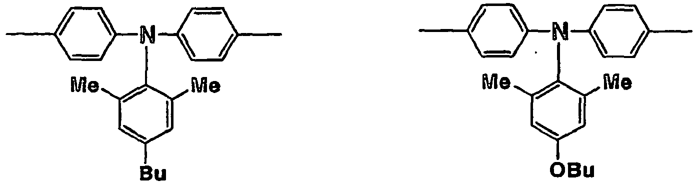

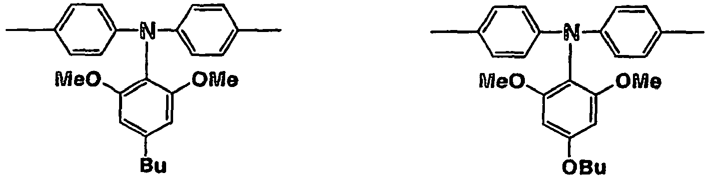

In the above formulae, Me represents a methyl group, Pr represents a propyl group which may be linear or branched, Bu represents a butyl group which may be linear or branched, MeO represents a methoxy group and BuO represents a butyloxy group which may be linear or branched, respectively.

The polymer compound of the present invention has one or more repeating units selected from the above formulae (2-1) and (2-2), in addition to a repeating unit of the above formula (1).

In the above formulae (2-1) and (2-2), A ring, B ring, C ring and D ring represent each independently an aromatic ring. The aromatic ring includes aromatic hydrocarbon rings such as a benzene ring, naphthalene ring, anthracene ring, tetracene ring, pentacene ring, pyrene ring, phenanthrene ring and the like; heteroaromatic rings such as a pyridine ring, bipyridine ring, phenanthroline ring, quinoline ring, isoquinoline ring, thiophene ring, furan ring, pyrrole ring and the like. The kind of the aromatic ring of A ring, B ring, C ring and D ring may be the same or different. Those in which A ring, B ring, C ring and D ring are aromatic hydrocarbon rings are preferable.

A ring, B ring, C ring and D ring may each independently have a substituent, and examples of the substituent include alkyl groups, alkoxy groups, alkylthio groups, aryl groups, aryloxy groups, arylthio groups, arylakyl groups, arylalkoxy groups, arylalkylthio groups, arylalkenyl groups, arylalkynyl groups, amino group, substituted amino groups, silyl group, substituted silyl groups, halogen atoms, acyl group, acyloxy group, imino group, amide group, acid imide group, monovalent heterocyclic groups, carboxyl group, substituted carboxyl groups and cyano group.

In the above formula (2-1), X represents -O-, -S-, -S(=O)-, -SO₂-, -C(R₁)(R₂)-, -B(R₃)-, -Si(R₄)(R₅)-, -P(R₆)-, -PR₇(=O)- or -N(R₈)-.

R₁, R₂, R₃, R₄, R₅, R₆, R₇ and R₈ represent each independently an alkyl group, alkoxy group, alkylthio group, aryl group, aryloxy group, arylthio group, arylakyl group, arylalkoxy group, arylalkylthio group, arylalkenyl group, arylalkynyl group, amino group, substituted amino group, silyl group, substituted silyl group, silyloxy group, substituted silyloxy group, monovalent heterocyclic group or halogen atom.

As specific examples of the alkyl group, alkoxy group, alkylthio group, aryl group, aryloxy group, arylthio group, arylakyl group, arylalkoxy group, arylalkylthio group, arylalkenyl group, arylalkynyl group, amino group, substituted amino group, silyl group, substituted silyl group, silyloxy group, substituted silyloxy group, monovalent heterocyclic group and halogen atom represented by R₁, R₂, R₃, R₄, R₅, R₆, R₇ and R₈, the same groups as shown for the above R are exemplified.

In the above formula (2-2), Y represents -CR₉=CR₁₀- or -C≡C-.

Here , R₉ and R₁₀ represent each independently a hydrogen atom, alkyl group, aryl group, mono-valent heterocyclic group, carboxyl group, substituted carboxyl group or cyano group.

As specific examples of the alkyl group, aryl group, mono-valent heterocyclic group, carboxyl group, substituted carboxyl group or cyano group represented by R₉ and R₁₀, the same groups as shown for the above R are exemplified.

In the above formula (2 - 2), Y preferably represents -CH=CH-.

The polymer compound of the present invention contains at least one repeating unit selected from repeating units of the above formulae (2-1) and (2-2), and preferably contains one or more repeating units selected from the above formula (2-1).

In the case of the formula (2-1), X represents more preferably -O-, -S- or -C(R₁)(R₂)-.

When X represents -C(R₁)(R₂)- in the above formula (2-1), A ring and B ring represent each independently preferably a single-cyclic aromatic ring, more preferably a single-cyclic aromatic hydrocarbon ring. Of them, those in which A ring and B ring represent each independently a benzene ring are preferable from the standpoint of simplicity of production of raw materials.

Specific examples of a repeating unit of the above formula (2-1) in which A ring and B ring represent an aromatic hydrocarbon ring and X represents a divalent group selected from -O- and -S- include the followings.

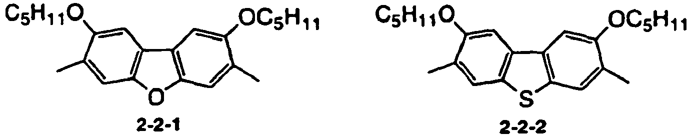

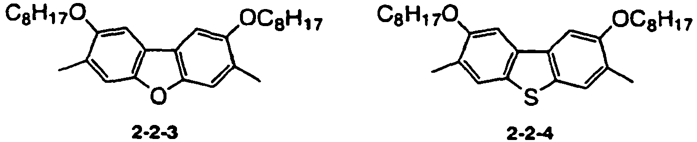

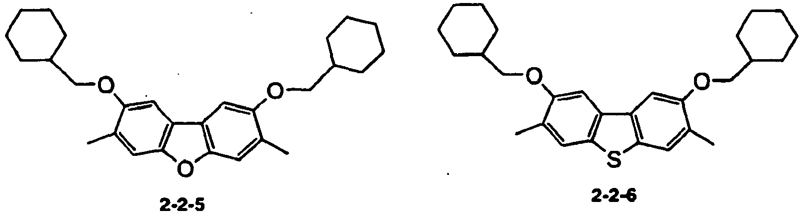

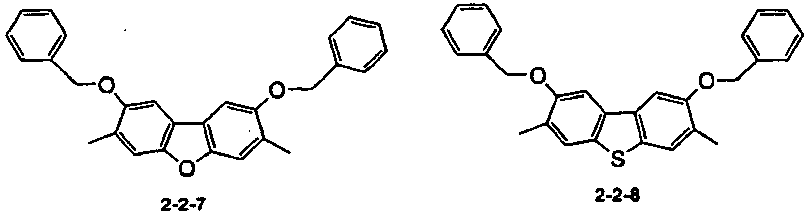

Of them, the above formulae (2-2-1), (2-2-3), (2-2-5) and (2-2-7) are further preferable from the standpoint of light emission efficiency.

Specific examples in which X represents -C(R₁)(R₂)- in (2-1) include the following groups.

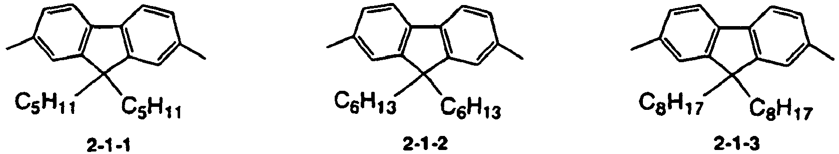

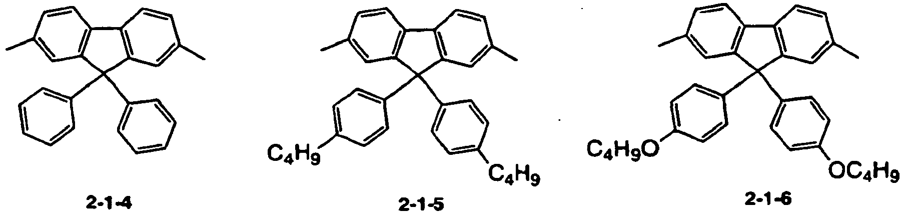

Specific examples of a repeating unit of the above formula (2-2 in which C ring and D ring represent an aromatic hydrocarbon ring and Y represents -CH=CH- include the followings.

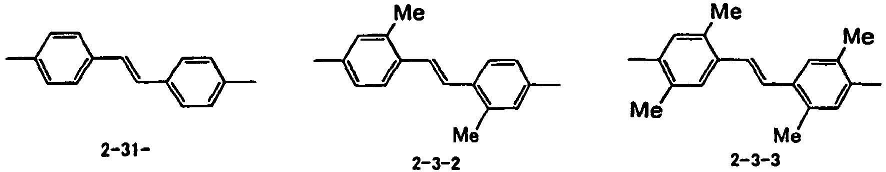

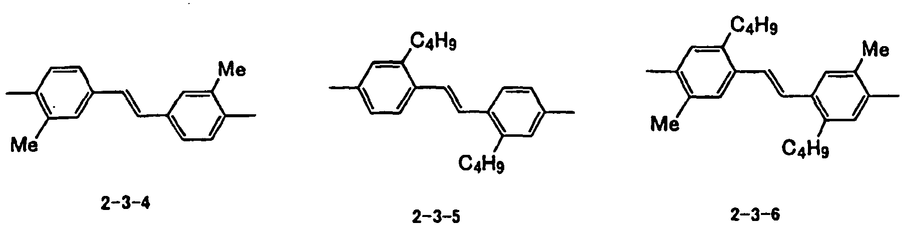

If the ratio (M1/M) of the mol number (M1) of a repeating unit of the above formula (1) to the sum (M) of mol numbers of all repeating units in a polymer compound of the present invention is represented by x and if the ratio (M2/M) of the sum (M2) of mol numbers of repeating units represented by the above formulae (2-1), (2-2) and (2-3) to the sum of mol numbers of all repeating units is represented by y, then, 0.01≤x+y≤1, preferably 0.1≤x+y≤1.

The ratio (x/(x+y)) of the mol number of a repeating unit of the formula (1) to the sum the mol number of a repeating unit of the formula (1) and the mol numbers of repeating units selected from repeating units of the formulae (2-1), (2-2) and (2-3) is preferably 0.01≤x/(x+y) ≤0.99, from the standpoint of light emission efficiency, more preferably 0.05≤x/(x+y) ≤0.60, and from the standpoint of heat resistance, more preferably 0.30≤x/(x+y)≤0.95, and particularly preferably 0.40≤x/(x+y)≤0.90.

The polymer compound of the present invention may contain a repeating unit other than repeating units of the formula (1) and the formulae (2-1) and (2-2).

As the repeating unit other than repeating units of the formula (1) and the formulae (2-1) and (2-2) which can be contained in the polymer compound of the present invention, repeating units of the following formula (4), (5), (6) or (7) are preferable.

-Ar₅- (4)

-Ar₅-X₁-(Ar₆-X₂)_{c}-Ar₇- (5)

-Ar₅-X₂- (6)

-X₂- (7)

In the above formulae, Ar₅, Ar₆ and Ar₇ represent each independently an arylene group, divalent heterocyclic group or divalent group having a metal complex structure. X₁ represents -C≡C-, -N(R₁₁)- or -(SiR₁₂R₁₃)_{d}, X₂ represents -CR₂₁=R₃₁-, -C≡C-, -N(R₁₁)- or -(SiR₁₂R₁₃)_{d}. R₂₁ and R₃₁ represent each independently a hydrogen atom, alkyl group, aryl group, mono-valent heterocyclic group, carboxyl group, substituted carboxyl group or cyano group. R₁₁, R₁₂ and R₁₃ represent each independently a hydrogen atom, alkyl group, aryl group, mono-valent heterocyclic group or arylalkyl group. c represents an integer of 0 to 2. d represents an integer of 1 to 12. When a plurality of Ar₆s, X₂s, R₁₁s, R₁₂s, R₁₃s, R₂₁s and R₃₁s are present, they may be the same or different.

Here, the arylene group and divalent heterocyclic group have the same meanings as described above.

The divalent group having a metal complex structure means a remaining divalent group obtained by removing two hydrogen atoms from an organic ligand of a metal complex.

The carbon number of an organic ligand in a metal complex is usually about 4 to 60. Examples of the organic ligand include 8-quinolinol and its derivatives, benzoquinolinol and its derivatives, 2-phenyl-pyridine and its derivatives, 2-phenyl-benzothiazole and its derivatives, 2-phenyl-benzoxazole and its derivatives, porphyrin and its derivatives, and the like.

Examples of the center metal of a metal complex having an organic ligand include aluminum, zinc, beryllium, iridium, platinum, gold, europium, terbium and the like.

The metal complex having an organic ligand includes those known as fluorescent materials and phosphorescent materials of lower molecular weight, so-called, triplet light emitting complexes, and the like.

Examples of the divalent group having a metal complex structure include the following groups (126 to 132).

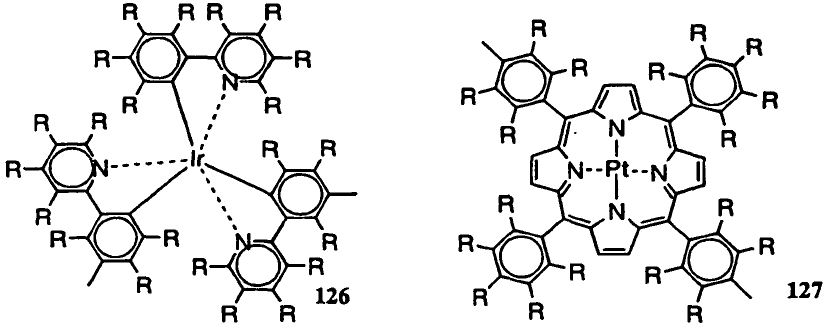

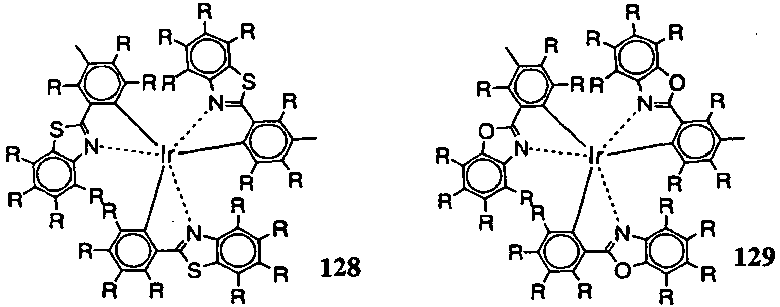

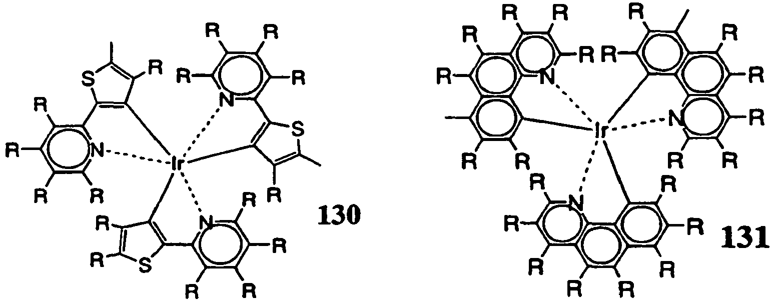

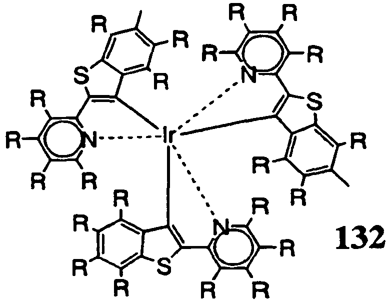

In the formulae, R represents the same meaning as in the above formulae 1 to 125.

Of repeating units other than the repeating units of the formula (1) and the formulae (2-1) and (2-2) which can be contained in the polymer compound of the present invention, preferable are repeating units of the above formulae (4) and (5).

Specific examples of the repeating unit of the above formula (5) include the following formulae (133 to 140).

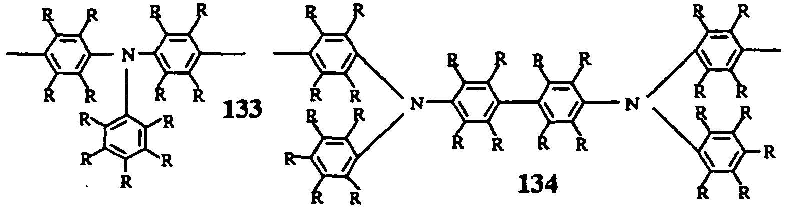

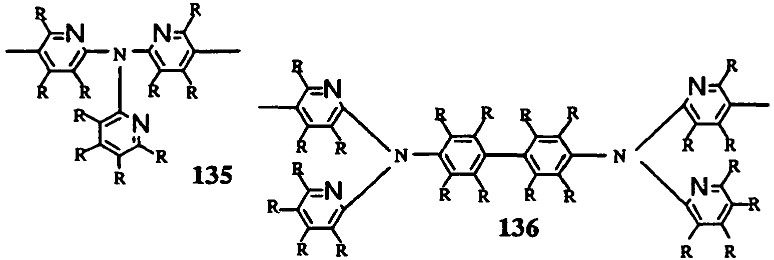

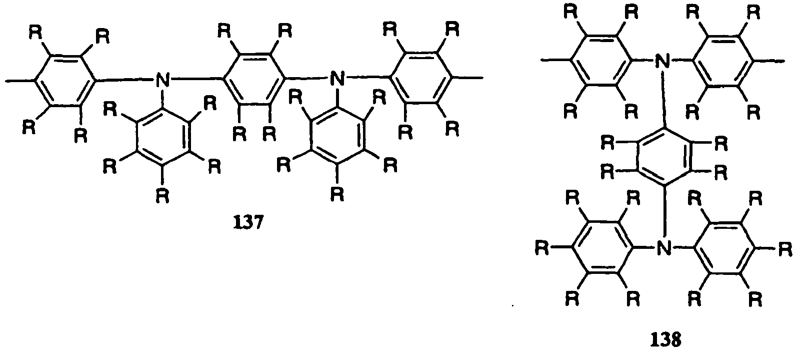

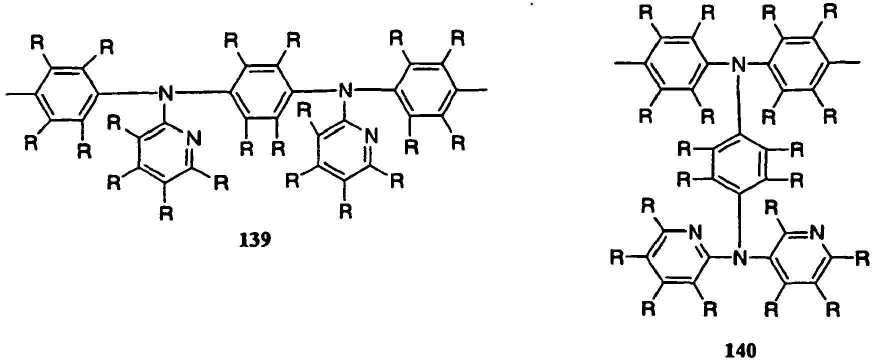

In the above formulae, R represents the same meaning as in the above formulae 1 to 132.

The polymer compound used in the present invention may contain a repeating unit other than the repeating unit of the formula (1), (2-1), (2-2), (4), (5), (6) or (7) in a range not deteriorating a light emitting property and charge transporting property. The repeating units may be connected with a non-conjugate unit, and the repeating unit may contain its non-conjugate portion. As the non-conjugate unit, exemplified are those shown below and combinations of two or more of them. Here, R represents a group selected from the same substituents as described above, and Ar represents a hydrocarbon group having 6 to 60 carbon atoms.

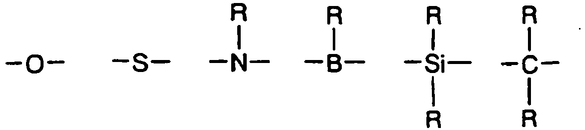

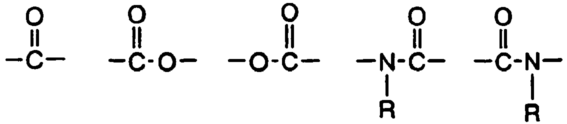

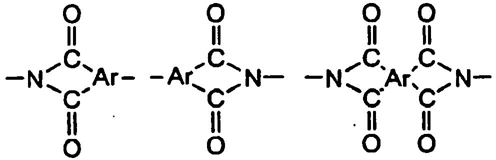

The polymer compound of the present invention may be a random, block or graft copolymer, or a polymer having an intermediate structure thereof, for example, a random copolymer having block property. From the standpoint of obtaining a light emitting material (light emitting material of high molecular weight) showing high fluorescent or phosphorescent quantum yield, random copolymers having block property, and block or graft copolymers are preferable more than complete random copolymers. The polymer compound of the present invention also includes those having branching in the main chain and three or more end parts, and dendrimers.

The end group of the polymer compound of the present invention may be protected with a stable group since if a polymerizable group remains intact, there is a possibility of decrease in light emitting property and life-time when the compound is made into a device. Those having a conjugated bond continuing to a conjugated structure of the main chain are preferable, and exemplified are structures connected to an arylene group or heterocyclic group via a carbon-carbon bond. Specifically, substituents described in chemical formulae 10 of Japanese Patent Application Laid-Open (JP-A) No. 9-45478 are exemplified.

The polymer compound used in the present invention has a polystyrene-reduced number-average molecular weight of usually about 10³ to 10⁸, preferably, 10⁴ to 10⁶.

As good solvents for the polymer compound used in the present invention, exemplified are chloroform, methylene chloride, dichloroethane, tetrahydrofuran, toluene, xylene, mesitylene, tetralin, decalin, n-butylbenzene and the like. Depending on the structure and molecular weight of the polymer compound, the polymer compound used in the present invention can be dissolved usually in an amount of 0.1 wt% or more in these solvents.

The polymer compound used in the present invention can be produced, for example, by condensation-polymerizing a compound of the following formula (8) and one or more compounds selected from the formulae (9-1) and (9-2) as raw materials. 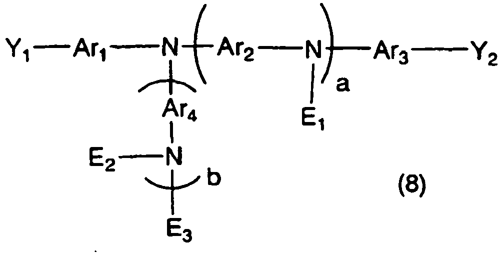 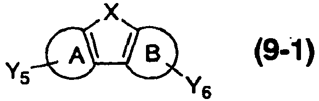 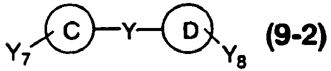 (wherein, Ar₁, Ar_{2,} Ar_{3,} Ar₄, E₁, E₂, E₃, A ring, B ring, C ring, D ring , X and Y have the same meanings as described above. Y₁, Y₂, Y₅, Y₆, Y₇ and Y₈ represent each independently a substituent participating in a condensation polymerization reaction.)

As the substituent participating in a condensation polymerization reaction, halogen atoms, alkylsulfonate groups, arylsulfonate groups, arylalkylsulfonate groups, borate groups, sulfoniummethyl group, phosphoniummethyl group, phosphonatemethyl group, mono-halogenated methyl group, boric group (-B(OH)₂), formyl group, cyano group, vinyl group and the like.

Here, as the alkylsulfonate group, a methanesulfonate group, ethanesulfonate group, trifluoromethanesulfonate group and the like are exemplified, as the arylsulfonate group, a benzenesulfonate group, p-toluenesulfonate group and the like exemplified, and as the arylalkylsulfonate group, a benzylsulfoante group and the like are exemplified.

As the borate group, groups of the following formulae are exemplified.

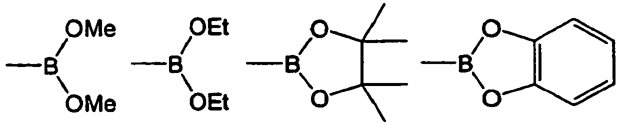

In the formulae, Me represents a methyl group and Et represents an ethyl group.

As the sulfoniummethyl group, groups of the following formulae are exemplified.

-CH₂S⁺Me₂X⁻, -CH₂S⁺Ph₂X⁻,

(X represents a halogen atom, and Ph represents a phenyl group.).

As the halosulfonyl group, groups of the following formula are exemplified.

-SO₂X

(X represents a halogen atom.).

As the phosphoniummethyl group, groups of the following formula are exemplified.

-CH₂P⁺Ph₃X⁻

(X represents a halogen atom.).

As the phosphonatemethyl group, groups of the following formula are exemplified.

-CH₂PO(OR')₂

(X represents a halogen atom, and R' represents an alkyl group, aryl group or arylalkyl group.).

As the mono-halogenated methyl group, methyl fluoride group, methyl chloride group, methyl bromide group, methyl iodide group and the like are exemplified.

Though preferable examples of the substituent participating in a condensation polymerization reaction differ depending on the kind of the polymerization reaction, when a zero-valent nickel complex is used such as, for example, in Yamamoto coupling reaction and the like, mentioned are halogen atoms, alkylsulfonate groups, arylsulfonate groups or arylalkylsulfonate groups. When a nickel catalyst or palladium catalyst is used such as in Suzuki coupling reaction and the like, mentioned are halogen atoms, borate groups, boric group and the like.

When the polymer compound of the present invention has a repeating unit other than the repeating units of the formula (1) and the formulae (2-1) and (2-2), condensation polymerization may be advantageously carried out in the co-existence of a compound having two substituents participating in the condensation polymerization reaction as a repeating unit other than the repeating units of the formula (1) and the formulae (2-1) and (2-2).

As the compound having substituents participating in the condensation polymerization reaction as a repeating unit other than the repeating units of the formula (1) and the formulae (2-1), (2-2) and (2-3), compounds of the following formulae (10) to (13) are mentioned.

By condensation-polymerizing a compound of any of the following formulae (10) to (13) in addition to compounds of the above formula (8) and/or the formulae (9-1) and (9-2), a polymer compound having at least one repeating unit of the formula (4), (5), (6) or (7) in addition to repeating units of the above formula (1) and the formulae (2-1) and (2-2) can be produced.

Y₉-Ar₅-Y₁₀ (10)

Y₉-Ar₅-X₁-(Ar₆-X₂)_{c}-Ar₇-Y₁₀ (11)

Y₉-Ar₅-X₂-Y₁₀ (12)

Y₉-X₂-Y₁₀ (13)

In the formulae, Ar₅, Ar₆, Ar₇, c, X₁ and X₂ have the same meanings as described above. Y₉ an Y₁₀ represent each independently a substituent participating in a condensation polymerization reaction.

As the condensation polymerization reaction in the method of producing a polymer compound of the present invention, known condensation reactions can be used depending on the substituent participating in the condensation polymerization reaction of a compound of the above formulae (10) to (13).

As the method of producing a polymer compound of the present invention, for example, a method of polymerizing from the corresponding monomer with a nickel catalyst or palladium catalyst such as in Suzuki coupling reaction and the like, a method of polymerizing by Grignard reaction, a method of polymerizing with a zero-valent nickel complex such as in Yamamoto coupling reaction and the like, a method of polymerizing with an oxidizer such as FeCl₃ and the like, a method of electrochemically oxidation-polymerizing, a method by decomposition of an intermediate polymer having a suitable leaving group, and the like are exemplified.

When the polymer compound used in the present invention has a vinylene group in a main chain, for example, a method described in JP-A No. 5-202355 is mentioned. Namely, there are exemplified methods of polymerization of a compound having a formyl group and a compound having a phosphoniummethyl group by Wittig reaction, polymerization of compounds having a formyl group and a phosphoniummethyl group by Wittig reaction, polymerization of a compound having a formyl group and a compound having a phosphonatemethyl group by Honer reaction, polymerization of compounds having a formyl group and a phosphonatemethyl group by Honer reaction, polymerization of a compound having a vinyl group and a compound having a halogen atom by Heck reaction, polycondensation of a compound having two or more mono-halogenated methyl groups by a dehydrohalogenation method, polycondensation of a compound having two or more sulfoniummethyl groups by a sulfonium salt decomposition method, polymerization of a compound having a formyl group and a compound having a cyano group by Knoevenagel reaction, and the like, and methods of polymerization of a compound having two or more formyl groups by McMurry reaction, and the like.

When the polymer compound of the present invention has a triple bond in a main chain, for example, Heck reaction and Sonogashira reaction can be utilized.

Of them, a method of polymerization with a nickel catalyst or palladium catalyst such as Suzuki coupling reaction and the like, a method of polymerization by Grignard reaction, a method of polymerization with a zero-valent nickel complex such as Yamamoto coupling reaction and the like, and methods of polymerization by Wittig reaction, polymerization by Heck reaction, polymerization by Sonogashira reaction and polymerization by Knoevenagel reaction are preferable since structure control is easy in these methods.

The reaction conditions will be described more specifically.

In the case of Wittig reaction, Horner reaction, Knoevengel reaction and the like, the reaction is carried out using an alkali in an amount of not less than equivalent, preferably 1 to 3 equivalents based on functional groups of a compound. The alkali is not particularly restricted, and for example, potassium-t-butoxide, sodium-t-butoxide, metal alcoholates such as sodium ethylate, lithium methylate and the like, hydride reagents such as sodium hydride and the like, amides such as sodiumamide and the like can be used. As the solvent, N,N-dimethylformamide, tetrahydrofuran, dioxane, toluene and the like are used. Usually, the reaction can be progressed at from room temperature to about 150ºC. The reaction time is, for example, from 5 minutes to 40 hours, and times for sufficient progress of polymerization may be advantageous, and since there is no necessity for leaving for a long period of time after completion of the reaction, the reaction time is preferably 10 minutes to 24 hours. The concentration in the reaction may be appropriately selected in a range from about 0.01 wt% to maximum soluble concentration since reaction efficiency is poor in the case of too dilute and reaction control is difficult in the case of too high concentration, and usually in a range from 0.1 wt% to 30 wt%. The Wittig reaction is described in Organic Reactions, vol. 14, p. 270 to 490, John Wiley & Sons, Inc., 1965, and the like. The Knoevenagel, Wittig and dehydrohalogenation reactions are described in Makromol. Chem., Macromol. Symp., vol. 12, p. 229 (1987).

In the case of Heck reaction, monomers are reacted in the presence of a base such as triethylamine and the like using a palladium catalyst. A solvent having relatively high boiling point such as N,N-dimethylformamide, N-methylpyrrolidone and the like is used, the reaction temperature is about 80 to 160ºC, and the reaction time is from about 1 hour to 100 hours. The Heck reaction is described, for example, in Polymer, vol. 39, p. 5241-5244 (1988).

In the case of Sonogashira reaction, monomers are reacted, in general, using N,N-dimethylformamide, amine solvent or ether solvent and the like in the presence of a base such as triethylamine and the like using a palladium catalyst and cuprous iodide. Depending on reaction conditions and reactivity of a polymerizable substituent of the monomer, it is usual that the reaction temperature is about -50 to 120ºC and the reaction time is about 1 to 100 hours. The Sonogashira reaction is descried, for example, in Tetrahedron Letters, vol. 40, p. 3347 to 3350 (1999) and Tetrahedron Letters, vol. 16, p. 4467 to 4470 (1975).

In the case of Suzuki reaction, for example, palladium(tetrakis(triphenylphosphine)], palladium acetates and the like are used as a catalyst, and an inorganic base such as potassium carbonate, sodium carbonate, barium hydroxide and the like, an organic base such as triethylamine and the like, and an inorganic salt such as cesium fluoride and the like are added in an amount of not less than equivalent, preferably 1 to 10 equivalents based on monomers and reacted. An inorganic salt may be reacted in the form of aqueous solution in a two-phase system. As the solvent, N,N-dimethylformamide, toluene, dimethoxyethane, tetrahydrofuran and the like are exemplified. Depending on the solvent, temperatures of about 50 to 160ºC are suitably used. The temperature may be raised near the boiling point of the solvent and refluxed. The reaction time is about 1 hour to 200 hours. The Suzuki reaction is described, for example, in Chem. Rev., vol. 95, p. 2457 (1995).

A case of use of a zero-valent nickel complex will be described. There are a method of using a zero-valent nickel complex, and a method of reacting a nickel salt in the presence of a reducing agent to produce zero-valent nickel in the system.

As the zero-valent nickel complex, bis(1,5-cyclooctadiene)nickel (0), (ethylene)bis(triphenylphosphine)nickel (0), tetrakis(triphenylphosphine)nickel and the like are exemplified, and of them, bis(1,5-cyclooctadiene)nickel (0) is preferable from the standpoint of versatility and cheapness.

Addition of a neutral ligand is preferable from the standpoint of improvement in yield.

Here, the neutral ligand is a ligand not having anion or cation, and exemplified are nitrogen-containing ligands such as 2,2'-bipyridyl, 1,10-phenanthroline, methylenebisoxazoline, N,N'-tetramethylethylenediamine and the like; tertiary phosphine ligands such as triphenylphosphine, tritolylphosphine, tributylphosphine, triphenoxyphosphine and the like, and nitrogen-containing ligands are preferable from the standpoint of versatility and cheapness, and 2,2'-bipyridyl is particularly preferable from the standpoint of high reactivity and high yield. Particularly, preferable is a system obtained by adding 2,2'-bipyridyl as a neutral ligand to a system containing bis(1,5-cyclooctadiene)nickel (0) , from the standpoint of improvement in yield of a polymer. In a method of producing a zero-valent nickel complex in a system, nickel chloride, nickel acetate and the like are mentioned as a nickel salt. As a reducing agent, zinc, sodium hydride, hydrazine and derivatives thereof, lithium aluminum hydride and the like are mentioned, and if necessary, ammonium iodide, lithium iodide, potassium iodide and the like are used as an additive.

Particularly, a production method is preferable in which Y₁, Y₂, Y₅, Y₆, Y₇ Y₈, Y₉ and Y₁₀ represent each independently a halogen atom, alkylsulfonate group, arylsulfonate group or arylalkylsulfonate group and condensation polymerization is carried out in the presence of a zero-valent nickel complex.

In this case, mentioned as raw material compounds are dihalogenated compounds, bis(alkylsulfonate) compounds, bis(arylsulfonate) compounds, bis(arylalkylsulfonate) compounds or halogen-alkylsulfonate compounds, halogen-arylsulfonate compounds, halogen-arylalkylsulfonate compounds, alkylsulfonate-arylsulfonate compounds, alkylsulfonate-arylalkylsulfonate compounds and arylsulfonate-arylalkylsulfonate compounds.

Of the production method of the present invention, a production method is preferable in which Y₁, Y₂, Y₅, Y₆. Y₇ ,Y₈, Y₉ and Y₁₀ represent each independently a halogen atom, alkylsulfonate group, arylsulfonate group, arylalkylsulfonate group, boric group or borate group, the ratio of the sum (J) of the mol number of a halogen atom, alkylsulfonate group, arylsulfonate group and arylalkylsulfonate group to the sum (K) of the mol number of boric group and borate group is substantially 1 (usually, K/J is in a range of 0.7 to 1.2) and condensation polymerization is carried out using a nickel catalyst or palladium catalyst.

In this case, mentioned as specific combination of raw material compounds are dihalogenated compounds, bis(alkylsulfonate) compounds, bis(arylsulfonate) compounds and bis(arylalkylsulfonate) compounds with diboric acid compounds and diborate compounds. Alternatively, mentioned are halogen-boric acid compounds, halogen-borate compounds, alkylsulfonate-boric acid compounds, alkylsulfonate-borate compounds, arylsulfonate-boric acid compounds, arylsulfonate-borate compounds, arylalkylsulfonate-boric acid compounds, arylalkylsulfonate-boric acid compounds and arylalkylsulfonate-borate compounds.

It is in general preferable that the organic solvent used for producing a polymer compound of the present invention is subjected to sufficient deoxygenation treatment and the reaction is progressed under an inert atmosphere for suppressing side reactions though varying depending on compounds to be used and the reaction. Similarly, dehydration treatment is preferably carried out. However, a case of reaction with water in a two-phase system such as Suzuki coupling reaction is not included in this occasion.

For progressing a polymerization reaction, an alkali or a suitable catalyst are added appropriately. These may be selected depending on the reaction to be used. Alkalis and catalysts which are sufficiently dissolved in a solvent used for the reaction are preferable. As a method of mixing an alkali or catalyst, a method in which a solution of an alkali or catalyst is added slowly while stirring the reaction solution under an inert atmosphere of argon, nitrogen and the like, or, in reverse, the reaction solution is added slowly to a solution of an alkali or catalyst is exemplified.

The polymerization time is usually about 5 minutes to 200 hours depending on the kind of polymerization and preferably within 10 hours from the standpoint of production cost.

The polymerization temperature is usually about -50 to 160ºC depending on the kind of polymerization and preferably 20 to 100ºC from the standpoint of high yield and low heating cost.

When the polymer compound of the present invention is used in a polymer LED, its purity affects performances of the device such as a light emitting property and the like, therefore, it is preferable that monomers before polymerization are purified by distillation, sublimation purification, re-crystallization, column chromatography or the like before polymerization. Further, it is preferable that, after polymerization, purification treatment is carried out by conventional separation operations such as acid washing, alkali washing, neutralization, water washing, organic solvent washing, re-precipitation, centrifugal separation, extraction, column chromatography, dialysis and the like, or purification operations, drying and other operations.

Next, the application of a polymer compound of the present invention will be described.

The polymer compound of the present invention usually shows fluorescence or phosphorescence under solid condition and can be used as a polymer light emitting body (light emitting material of high molecular weight). A polymer LED using this polymer light emitting body is a polymer LED of high performance which can be driven at high efficiency. Therefore, the polymer LED can be preferably used for apparatuses such as light sources in the form of curved surface or sheet for illumination or backlight of a liquid crystal display, display devices of segment type, dot matrix flat panel displays and the like.

The polymer compound of the present invention can also be used as a coloring matter for laser, a material for organic solar battery, an organic semiconductor for organic transistor, a material for conductive films such as an electrically conductive film, organic semiconductor film and the like.

Further, the polymer compound of the present invention can also be used as a light emitting film material emitting fluorescence or phosphorescence.

Next, the polymer LED of the present invention will be described.

The polymer LED of the present invention is characterized in that a polymer compound of the present invention exists between electrodes composed of an anode and a cathode.

The layer containing a polymer compound of the present invention may be any of a light emitting layer, hole transporting layer, electron transporting layer and the like, and a light emitting layer is preferable.

Here, the light emitting layer means a layer having a function of emitting light, the hole transporting layer means a layer having a function of transporting holes, and the electron transporting layer means a layer having a function of transporting electrons. The electron transporting layer and hole transporting layer are collectively called a charge transporting layer. Each two or more layers of the light emitting layer, hole transporting layer and electron transporting layer may be used independently.

When the layer containing a polymer compound of the present invention is a light emitting layer, the organic layer may further contain a hole transporting material, electron transporting material or light emitting material. Here, the light emitting material denotes a material manifesting fluorescence and/or phosphorescence.

When a polymer compound of the present invention and a hole transporting material are mixed, the mixing proportion of the hole transporting material is 1 wt% to 80 wt%, preferably 5 wt% to 60 wt%, based on the total weight of the mixture. When a polymer compound of the present invention and an electron transporting material are mixed, the mixing proportion of the electron transporting material is 1 wt% to 80 wt%, preferably 5 wt% to 60 wt%, based on the total weight of the mixture. When a polymer compound of the present invention and a light emitting material are mixed, the mixing proportion of the light emitting material is 1 wt% to 80 wt%, preferably 5 wt% to 60 wt%, based on the total weight of the mixture. When a polymer compound of the present invention and a light emitting material, hole transporting material and/or electron transporting material are mixed, the mixing proportion of the light emitting material is 1 wt% to 50 wt%, preferably 5 wt% to 40 wt%, the total amount of the hole transporting material and electron transporting material is 1 wt% to 50 wt%, preferably 5 wt% to 40 wt%, and content of the polymer compound of the present invention is 99 wt% to 20 wt%.

As the hole transporting material, electron transporting material and light emitting material to be mixed, known low molecular weight compounds and high molecular weight compounds can be used, and high molecular weight compounds are preferably used. As the hole transporting material, electron transporting material and light emitting material of a high molecular weight compound, exemplified are polyfluorene, its derivatives and copolymers, polyarylene, its derivatives and copolymers, polyarylenevinylene, its derivatives and copolymers, (co) polymer of aromatic amines and its derivatives disclosed in WO 9 9/13692. WO 99/48160, GB-2340304A, WO00/53656, WO01/19834, WO00/55927, GB23483 16, WO00/46321, WO00/06665, WO99/54943, WO99 /54385, US5777070, WO98/06773, WO97/05184, W O00/35987, WO00/53655, WO01/34722, WO99/245 26, WO00/22027, WO00/22026, WO98/27136, US57 3636, WO98/21262, US 741921, WO97/09394, WO9 6/29356, WO96/10617. EP 0707020, WO95/07955, JP-A No. 2001-181618, JP-A No. 2001-123156, JP-A No. 2001-3045, JP-A No. 2000-35.1967, JP-A No. 2000-303066, JP-A No. 2000-299189, JP-A No. 2000-252065, JP-A No. 2000-136379, JP-A No. 2000-104057, JP-A No. 2000-80167, JP-A No. 10-324870, JP-A No. 10-114891, JP-A No. 9-111233, JP-A No. 9-45478 and the like, and high molecular weight compounds having repeating units selected from the above formulae (2-1), (2-2) and (2-3).

As the low molecular weight fluorescent material, for example, naphthalene derivatives, anthracene or its derivatives, perylene or its derivatives, and polymethine, xanthene, coumarine and cyanine coloring matters, metal complexes of 8-hydroxyquinoline or its derivatives, aromatic amines, tetraphenylcyclopentadiene or its derivatives, tetraphenylbutadiene or its derivatives, and the like can be used.

Specifically, known materials such as those described, for example, in JP-A Nos. 57-51781 and 59-194393, and the like can be used.

Examples of the low molecular weight phosphorescent material include triplet light emitting complexes such as Ir(ppy)₃ and Btp₂Ir (acac) containing iridium as a center metal, PtOEP containing platinum as a center metal, Eu(TTA)₃phen containing europium as a center metal, and the like.

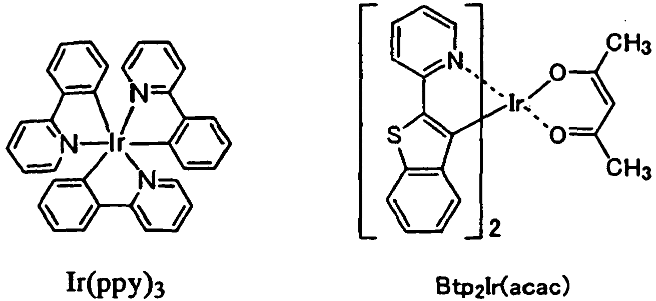

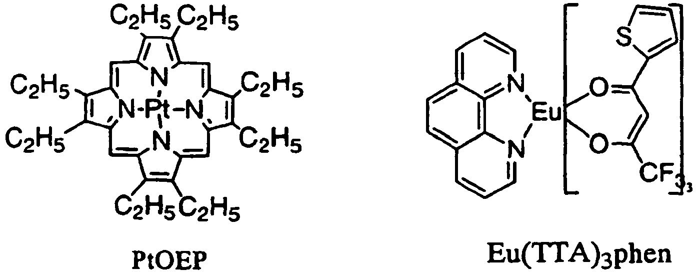

The triplet light emitting complexes are specifically described in, for example, Nature, (1998), 395, 151, Appl. Phys. Lett. (1999), 75(1), 4, Proc. SPIE-Int. Soc. Opt. Eng. (2001), 4105(Organic Light-Emitting Materials and Devices IV), 119. J. Am. Chem. Soc., (2001), 123, 4304. Appl. Phys. Lett., (1997), 71 (18), 2596, Syn. Met., (1998), 94(1), 103, Syn. Met., (1999), 99(2), 136 1. Adv. Mater., (1999), 1 1(10),852 Jpn.J.Appl.Phys.,34, 1 883 (1995) and the like.

The polymer compound of the present invention can be mixed with at least one material selected from hole transporting materials, electron transporting materials and light emitting materials and used as a light emitting material or charge transporting material. The composition may contain two or more polymer compounds of the present invention.

The content ratio of at least one material selected from hole transporting materials, electron transporting materials and light emitting materials and a polymer compound of the present invention may be determined depending on the application, and in the case of an application of a light emitting material, the same content ratio as in the above light emitting layer is preferable.

The optimum value of the thickness of a light emitting layer in a polymer LED of the present invention varies depending on the material to be used, and may be advantageously selected so that the driving voltage and light emission efficiency show suitable values, and for example, it is 1 nm to 1 µm, preferably 2 nm to 500 nm, further preferably 5 nm to 200 nm.

As the method of forming a light emitting layer, for example, a method of film formation from a solution is exemplified. As the method of film formation from a solution, there can be used application methods such as a spin coat method, casting method, micro gravure coat method, gravure coat method, bar coat method, role coat method, wire bar coat method, dip coat method, spray coat method, screen printing method, flexo printing method, offset printing method, inkjet printing method and the like. Printing methods such as a screen printing method, flexo printing method, offset printing method, inkjet printing method and the like are preferable since pattern formation and multi-color painting are easy.

Regarding the solution (ink composition) used in a printing method and the like, it is advantageous that at least one polymer compound according to the present invention is contained, and additives such as a hole transporting material, electron transporting material, light emitting material, solvent, stabilizer and the like may be contained in addition to the polymer compound of the present invention.

The proportion of a polymer compound of the present invention in the ink composition is 20 wt% to 100 wt% , preferably 40 wt% to 100 wt% based on the total weight of the composition excluding a solvent.

When the ink composition contains a solvent, the proportion of the solvent is 1 wt% to 99.9 wt%, preferably 60 wt% to 99.5 wt%, further preferably 80 wt% to 99.0 wt% based on the total weight of the composition.

Though the viscosity of the ink composition varies depending on a printing method, when an ink composition passes through a discharge apparatus such as in an inkjet printing method and the like, it is preferable that the viscosity at 25ºC is in a range of 1 to 20 mPa·s for preventing clogging in discharging and bending in flying, and more preferably in a range of 5 to 20 mPa·s, further preferably in a range of 7 to 20 mPa·s.

The solution of the present invention may contain additives for controlling viscosity and/or surface tension in addition to the polymer compound of the present invention. As the additives, a polymer compound of high molecular weight for enhancing viscosity (thickening agent) and a poor solvent, a compound of low molecular weight for lowering viscosity, a surfactant for decreasing surface tension, and the like may be used in appropriate combination.

As the above polymer compound of high molecular weight may advantageously be a compound which is soluble in the same solvent as for a polymer compound of the present invention and does not disturb light emission and charge transportation. For example, polystyrene and polymethyl methacrylate of high molecular weight, or those having high molecular weight among polymer compounds of the present invention, and the like, can be used. The weight-average molecular weight is preferably 500000 or more, more preferably 1000000 or more.

A poor solvent can also be used as a thickening agent. Namely, by adding small amount of a poor solvent for solid components in a solution, the viscosity can be enhanced. When a poor solvent is added for this purpose, it may be advantages to select the kind and addition amount of a solvent in a range not causing deposition of solid components in a solution. In view of stability in preservation, the amount of a poor solvent is preferably 50 wt% or less, further preferably 30 wt% or less based on the whole solution.

The solution of the present invention may contain an antioxidant in addition to a polymer compound of the present invention for improving preservation stability. The antioxidant may advantageously be a compound which is soluble in the same solvent as for a polymer compound of the present invention and does not disturb light emission and charge transportation, and exemplified are phenol antioxidants, phosphorus antioxidants, and the like.

As the solvent to be used for film formation from a solution, those capable of dissolving or uniformly dispersing a polymer compound are preferable. Exemplified as the solvent are chlorine solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, ethyl cellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof, alcohol solvents such as methanol, ethanol, propanol, isopropanol, cyclohexanol and the like, sulfoxide solvents such as dimethyl sulfoxide and the like, and amide solvents such as N-methyl-2-pyrrolidone, N,N-dimethylformamide, and the like. These organic solvents may be used singly or in combination of two or more. Of the above solvents, one or more organic solvents having a structure containing at least one benzene ring and having a melting point of 0ºC or less and a boiling point of 100ºC or more are preferably contained.

The kind of the solvent is preferably an aromatic hydrocarbon solvent, aliphatic hydrocarbon solvent, ester solvent or ketone solvent from the standpoints of solubility in an organic solvent, uniformity in film formation, viscosity property and the like, and preferable are toluene, xylene, ethylbenzene, diethylbenzene, trimethylbenzene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, 2-propylcyclohexanone, 2-heptanone, 3-heptanone, 4-heptanone, 2-octanone, 2-nonanone, 2-decanone and dicyclohexylketone, and it is more preferable that at least one of xylene, anisole, cyclohexylbenzene and bicyclohexyl is contained.

The number of solvents in a solution is preferably 2 or more, more preferably 2 to 3, further preferably 2 from the standpoint of film formability and from the standpoint of device properties and the like.

When two solvents are contained in a solution, one solvent of them may be solid at 25ºC. From the standpoint of film formability, it is preferable that one is a solvent having a boiling point of 180ºC or more and another is a solvent having a boiling point of 180ºC or less and it is more preferable that one is a solvent having a boiling point of 200ºC or more and another is a solvent having a boiling point of 180ºC or less. From the standpoint of viscosity, it is preferable that both of two solvents dissolve a polymer compound in an amount of 1 wt% or more at 60ºC and it is more preferable that one of two solvents dissolves a polymer compound in an amount of 1 wt% or more at 25ºC.

When three kinds of solvents are contained in a solution, one or two solvents of them may be solid at 25ºC. From the standpoint of film formability, it is preferable that at least one of three solvents is a solvent having a boiling point of 180ºC or more and at least one is a solvent having a boiling point of 180ºC or less and it is more preferable that at least one of three solvents is a solvent having a boiling point of 200QC or more and 300ºC or less and at least one is a solvent having a boiling point of 180ºC or less. From the standpoint of viscosity, it is preferable that two of three solvents dissolve a polymer compound in an amount of 1 wt% or more at 60ºC and it is more preferable that one of three solvents dissolves a polymer compound in an amount of 1 wt% or more at 25ºC.

When two or more kinds of solvents are contained in a solution, it is preferable that the proportion of a solvent having the highest boiling point is 40 to 90 wt%, more preferably 50 to 90 wt%, further preferably 65 to 85 wt%, from the standpoints of viscosity and film formability.

As the solution of the present invention, preferable are a solution composed of anisole and bicyclohexyl, a solution composed of anisole and cyclohexylbenzene, a solution composed of xylene and bicyclohexyl and a solution composed of xylene and-cyclohexylbenzene, from the standpoints of viscosity and film formability.

It is preferable that a difference between the solubility parameter of a solvent and the solubility parameter of a polymer compound is 10 or less, more preferably 7 or less, from the standpoint of solubility of a polymer compound into a solvent.

The solubility parameter of a solvent and the solubility parameter of a polymer compound can be obtained by a method described in "Solvent Handbook (published by Kodansha Ltd. Publisher, 1976)".

One or two or more polymer compounds of the present invention may be contained in a solvent, and a polymer compound other than the polymer compound of the present invention may be contained in a range not deteriorating device properties and the like.

The solution of the present invention may contain water, metal and its salt in an amount of 1 to 1000 ppm. The metal includes specifically lithium, sodium, calcium, potassium, iron, copper, nickel, aluminum, zinc, chromium, manganese, cobalt, platinum, iridium and the like. Further, silicon, phosphorus, fluorine, chlorine and bromine may be contained in an amount of 1 to 1000 ppm.

When a film is produced using a solution of the present invention, it is possible to effect baking at a temperature of 100QC or more since the glass transition temperature of a polymer compound contained in the solution is high, and thus, lowering of device properties is extremely small even if baking is performed at a temperature of 130ºC. Depending on the kind of a polymer compound, it is also possible to effect baking at a temperature of 160ºC or more.

As the film which can be produced using a solution of the present invention, exemplified are light emitting films, electrically conductive films and organic semiconductor films.

The light emitting film of the present invention has a quantum yield of light emission of preferably 50% or more, more preferably 60% or more, further preferably 70% or more from the standpoints of the luminance and light emission voltage of a device and the like.

The electrically conductive film of the present invention has a surface resistance preferably of 1 KΩ/□ or less. By doping a film with Lewis acid, ionic compound and the like, electric conductivity can be enhanced. The surface resistance is more preferably 100 KΩ/□ or less, further preferably 10 KΩ/□.

In the organic semiconductor film of the present invention, it is preferable that the larger matter of electron mobility or hole mobility is 10⁻⁵ cm²/V/sec. or more. It is more preferably 10⁻³ cm²/V/sec. or more, further preferably 10⁻¹ cm²/V/sec. or more.

An organic transistor can be obtained by forming the organic semiconductor film on a Si substrate carrying an insulation film formed thereon made of SiO₂ and the like, and a gate electrode formed thereon, and forming a source electrode and a drain electrode with Au and the like.

In the polymer light emitting device of the present invention, it is preferable that, when a voltage of 3.5 V or more is applied between an anode and a cathode, the maximum outer quantum yield is 1% or more, and more preferably 1.5% or more, from the standpoint of the luminance of the device and the like.

Listed as the polymer light emitting device of the present invention (hereinafter, referred to as polymer LED) are a polymer LED having an electron transporting layer provided between a cathode and a light emitting layer, a polymer LED having a hole transporting layer provided between an anode and a light emitting layer, a polymer LED having an electron transporting layer provided between a cathode and a light emitting layer, and having a hole transporting layer provided between an anode and a light emitting layer, and the like.

For example, the following structures a) to d) are specifically exemplified.
a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode
(wherein, / denotes adjacent lamination of layers, applicable also in the following descriptions)

The polymer LED of the present invention includes also those in which a polymer compound of the present invention is contained in a hole transporting layer and/or electron transporting layer.

When the polymer compound of the present invention is used in a hole transporting layer, it is preferable that the polymer compound of the present invention is a polymer compound containing a hole transporting group, and specific examples thereof include a copolymer with an aromatic amine, a copolymer with stilbene, and the like.

When the polymer compound of the present invention is used in an electron transporting layer, it is preferable that the polymer compound of the present invention is a polymer compound containing an electron transporting group, and specific examples thereof include a copolymer with oxadiazole, a copolymer with triazole, a copolymer with quinoline, a copolymer with quinoxaline, a copolymer with benzothiaziazole, and the like.

When the polymer LED of the present invention has a hole transporting layer, exemplified as the hole transporting material to be used are polyvinylcarbazole or its derivatives, polysilane or its derivatives, polysiloxane derivatives having an aromatic amine in a side chain or main chain, pyrazoline derivatives, arylamine derivatives, stilbene derivatives, triphenyldiamine derivatives, polyaniline or its derivatives, polythiophene or its derivatives, polypyrrole or its derivatives, poly(p-phenylenevinylene) or its derivatives, poly(2,5-thienylenevinylene) or its derivatives, and the like.

Specifically, exemplified as the hole transporting material are those described in JP-A Nos. 63-70257 and 63-175860, JP-A Nos. 2-135359, 2-135361, 2-209988, 3-37992 and 3-152184, and the like.

Of them, preferable as the hole transporting material used in a hole transporting layer are high molecular weight hole transporting materials such as polyvinylcarbazole or its derivatives, polysilane or its derivatives, polysiloxane derivatives having an aromatic amine compound group in a side chain or main chain, polyaniline or its derivatives, polythiophene or its derivatives, poly(p-phenylenevinylene) or its derivatives, poly(2,5-thienylenevinylene) or its derivatives, and the like, and further preferable are polyvinylcarbazole or its derivatives, polysilane or its derivatives and polysiloxane derivatives having an aromatic amine in a side chain or main chain.

As the hole transporting material of a low molecular weight compound, exemplified are pyrazoline derivatives, arylamine derivatives, stilbene derivatives and triphenyldiamine derivatives. In the case of a low molecular weight hole transporting material, it is preferably dispersed in a polymer binder in use.

As the polymer binder to be mixed, those not extremely disturbing charge transportation are preferable and those showing no strong absorption for visible ray are suitably used. As the polymer binder, exemplified are poly(N-vinylcarbazole), polyaniline or its derivatives, polythiophene or its derivatives, poly(p-phenylenevinylene) or its derivatives, poly(2,5-thienylenevinylene) or its derivatives, polycarbonate, polyacrylate, polymethyl acrylate, polymethyl methacrylate, polystyrene, polyvinyl chloride, polysiloxane and the like.

Polyvinylcarbazole or its derivatives are obtained, for example, from vinyl monomers by cation polymerization or radical polymerization.

As polysilane or its derivatives, compounds described in Chem. Rev., vol. 89, p. 1359 (1989), GB Patent No. 2300196 and the like are exemplified. Also as the synthesis method, methods described in these publications can be used, and particularly, Kipping method is suitably used.

As polysiloxane or its derivatives , those having a structure of the above low molecular weight hole transporting material in its side chain or main chain are suitable since the siloxane skeleton structure shows little hole transporting property. Particularly, those having a hole transporting aromatic amine in a side chain or main chain are exemplified.

Though the method of forming a hole transporting layer is not particularly restricted, a method of film formation from a mixed solution with a polymer binder is exemplified in the case of a low molecular weight hole transporting material. A method of film formation from a solution is exemplified in the case of a high molecular weight hole transporting material.

As the solvent used for film formation from a solution, those which can dissolve or uniformly disperse a hole transporting material are preferable. Exemplified as the solvent are chlorine solvents such as chloroform, methylene chloride, 1,2-dichloroethane. 1.1,2-trlchloroethane, chlorobenzene, o-dichlorobenzene and the like, ether solvents such as tetrahydrofuran, dioxane and the like, aromatic hydrocarbon solvents such as toluene, xylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, ethyl cellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof, alcohol solvents such as methanol, ethanol, propanol, isopropanol, cyclohexanol and the like, sulfoxide solvents such as dimethyl sulfoxide and the like, and amide solvents such as N-methyl-2-pyrrolidone, N,N-dimethylformamide, and the like. These organic solvents may be used singly or in combination of two or more.

As the method of film formation from a solution, there can be used application methods such as a spin coat method, casting method, micro gravure coat method, gravure coat method, bar coat method, role coat method, wire bar coat method, dip coat method, spray coat method, screen printing method, flexo printing method, offset printing method, inkjet printing method and the like from a solution.

The optimum value of the thickness of a hole transporting layer varies depending on a material to be used, and the thickness may be advantageously selected so as to give suitable driving voltage and light emission efficiency, and at least thickness not causing generation of pin holes is necessary, and when too thick, the driving voltage of a device increases undesirably. Thus, the thickness of the hole transporting layer is, for example, 1 nm to 1 µm, preferably 2 nm to 500 nm, further preferably 5 nm to 200 nm.

When the polymer LED of the present invention has an electron transporting layer, known materials can be used as an electron transporting material to be used, and exemplified are oxadiazole derivatives, anthraquinodimethane or its derivatives, benzoquinone or its derivatives, naphthoquinone or its derivatives, anthraquinone or its derivatives, tetracyanoanthraquinodimethane or its derivatives, fluorenone derivatives, diphenyldicyanoethylene or its derivatives, diphenoquinone derivatives, or metal complexes of 8-hydroxyquinoline or its derivatives, polyquinoline or its derivatives, polyquinoxaline or its derivatives, polyfluorene or its derivatives, and the like.

Specifically, those described in JP-A Nos. 63-70257 and 63-175860, JP-A Nos. 2-135359, 2-135361, 2-209988, 3-37992 and 3-152184, and the like are exemplified.

Of them, oxadiazole derivatives, benzoquinone or its derivatives, anthraquinone or its derivatives, or metal complexes of 8-hydroxyquinoline or its derivatives, polyquinoline or its derivatives, polyquinoxaline or its derivatives, polyfluorene or its derivatives are preferable, and 2-(4-biphenylyl)-5-(4-t-butylphenyl)-1,3,4-oxadiazole, benzoquinone, anthraquinone, tris(8-quinolinol)aluminum and polyquinoline are further preferable.

The method of forming an electron transporting layer is not particularly restricted, and in the case of a low molecular weight electron transporting material, a vacuum vapor deposition method from a powder, or a film formation method from solution or melted condition is exemplified, and in the case of a high molecular weight electron transporting material, a film formation method from solution or melted condition is exemplified, respectively. In film formation from solution or melted condition, the above polymer binder may be used together.

As the solvent used for film formation from a solution, those which can dissolved or uniformly disperse an electron transporting material and/or polymer binder are suitable. Exemplified as the solvent are chlorine solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, ethyl cellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof, alcohol solvents such as methanol, ethanol, propanol, isopropanol, cyclohexanol and the like, sulfoxide solvents such as dimethyl sulfoxide and the like, and amide solvents such as N-methyl-2-pyrrolidone, N,N-dimethylformamide, and the like. These organic solvents may be used singly or in combination of two or more.

As the method of film formation from a solution, there can be used application methods such as a spin coat method, casting method, micro gravure coat method, gravure coat method, bar coat method, role coat method, wire bar coat method, dip coat method, spray coat method, screen printing method, flexo printing method, offset printing method, inkjet printing method and the like from a solution.

The optimum value of the thickness of a hole transporting layer varies depending on a material to be used, and the thickness may be advantageously selected so as to give suitable driving voltage and light emission efficiency, and at least thickness not causing generation of pin holes is necessary, and when too thick, the driving voltage of a device increases undesirably. Thus, the thickness of the hole transporting layer is, for example, 1 nm to 1 µm, preferably 2 nm to 500 nm, further preferably 5 nm to 200 nm.

Of charge transporting layers provided adjacent to an electrode, those having a function of improving charge injection efficiency from an electrode and having an effect of lowering driving voltage of a device are, in general, called particularly a charge injecting layer (hole injecting layer, electron injecting layer) in some cases.

Further, for improving close adherence with an electrode and improving charge injection from an electrode, the above charge injection layer or an insulation layer having a thickness of 2 nm or less may be provided adjacently to an electrode, and for improving close adherence of an interface and preventing mixing, and the like, a thin buffering layer may be inserted in an interface of a charge transporting layer or a light emitting layer.

The order and number of layers to be laminated, and the thicknesses of respective layers can be appropriately selected in view of light emission efficiency and device life.

In the present invention, listed as the polymer LED having a provided charge injection layer (electron injection layer, hole injection layer) are a polymer LED having a charge injection layer provided adjacently to a cathode and a polymer LED having a charge injection layer provided adjacently to an anode;

For example, the following structures e) to p) are specifically mentioned.
e) anode/hole injection layer/light emitting layer/cathode
f) anode/light emitting layer/electron injection layer/cathode
g) anode/hole injection layer/light emitting layer/electron injection layer/cathode
h) anode/hole injection layer/hole transporting layer/light emitting layer/cathode
i) anode/hole transporting layer/light emitting layer/electron injection layer/cathode
j) anode/hole injection layer/hole transporting layer/light emitting layer/electron injection layer/cathode
k) anode/hole injection layer/light emitting layer/electron transporting layer/cathode
l) anode/light emitting layer/electron transporting layer/electron injection layer/cathode
m) anode/hole injection layer/light emitting layer/electron transporting layer/electron injection layer/cathode
n) anode/hole injection layer/hole transporting layer/light emitting layer/electron transporting layer/cathode
o) anode/hole transporting layer/light emitting layer/electron transporting layer/electron injection layer/cathode
p) anode/hole injection layer/hole transporting layer/light emitting layer/electron transporting layer/electron injection layer/cathode

The polymer LED of the present invention includes also those having a polymer compound of the present invention contained in a hole transporting layer and/or electron transporting layer, as described above.

Further, the polymer LED of the present invention includes also those having a polymer compound of the present invention contained in a hole injection layer and/or electron injection layer. When a polymer compound of the present invention is used in a hole injection layer, it is preferable that this is used simultaneously with an electron receptive compound. When a polymer compound of the present invention is used in an electron transporting layer, it is preferable that this is used simultaneously with an electron donative compound. Here, methods of mixing, copolymerization, introduction as a side chain, and the like are mentioned for simultaneously used.

As specific examples of the charge injection layer, there are exemplified a layer containing an electrically conductive polymer, a layer provided between an anode and a hole transporting layer and containing a material having ionization potential of an intermediate value between that of an anode material and that of a hole transporting material contained in the hole transporting layer, a layer provided between a cathode and an electron transporting layer and containing a material having electron affinity of an intermediate value between that of a cathode material and that of an electron transporting material contained in the electron transporting layer, and the like.

When the above charge injection layer contains an electrically conductive polymer, the electric conductivity of the electrically conductive polymer is preferably 10⁻⁵ S/cm or more and 10³ or less, and for decreasing leak current between light emitting picture elements, more preferably 10⁻⁵ S/cm or more and 10² or less, further preferably 10⁻⁵ S/cm or more and 10¹ or less.

When the above charge injection layer contains an electrically conductive polymer, the electric conductivity of the electrically conductive polymer is preferably 10⁻⁵ S/cm or more and 10³ s/cm or less, and for decreasing leak current between light emitting picture elements, more preferably 10⁻⁵ S/cm or more and 10² s/cm or less, further preferably 10⁻⁵ S/cm or more and 10¹ s/cm or less.

Usually, for setting the electric conductivity of the electrically conductive polymer at 10⁻⁵ S/cm or more and 10³ or less, the electrically conductive polymer is doped with suitable amount of ions.

Regarding the kind of an ion to be doped, an anion is used in a hole injection layer and a cation is used in an electron injection layer. Examples of the anion include a polystyrenesulfonate ion, alkylbenzenesulfonate ion, camphorsulfonate ion and the like, and examples of the cation include a lithium ion, sodium ion, potassium ion, tetrabutylammonium ion and the like.

The thickness of a charge injection layer is, for example, 1 nm to 100 nm, preferably 2 nm to 50 nm.

The material used in a charge injection layer may be advantageously selected appropriately in relation to a material of an electrode or adjacent layer, and exemplified are polyaniline and its derivatives, polythiophene and its derivatives, pyrrole and its derivatives, polyphenylenevinylene and its derivatives, polythienylenevinylene and its derivatives, polyquinoline and its derivatives, polyquinoxaline and its derivatives, electrically conductive polymers such as a polymer containing an aromatic amine structure in a main chain or side chain, metal phthalocyanine(copper phthalocyanine and the like), carbon and the like.

The insulation layer having a thickness of 2 nm or less has a function of making charge injection easy. As the material of the above insulation layer, metal fluorides, metal oxides, organic insulation materials and the like are mentioned. As the polymer LED provided with an insulation layer having a thickness of 2 nm or less, there are mentioned a polymer LED having an insulation layer having a thickness of 2 nm or less provided adjacently to a cathode and a polymer LED having an insulation layer having a thickness of 2 nm or less provided adjacently to an anode.

Specifically, the following structures q) to ab) are listed, for example.
q) anode/insulation layer having a thickness of 2 nm or less/light emitting layer/cathode
r) anode/light emitting layer/insulation layer having a thickness of 2 nm or less/cathode
s) anode/insulation layer having a thickness of 2 nm or less/light emitting layer/insulation layer having a thickness of 2 nm or less/cathode
t) anode/insulation layer having a thickness of 2 nm or less/hole transporting layer/light emitting layer/cathode
u) anode/hole transporting layer/light emitting layer/insulation layer having a thickness of 2 nm or less/cathode
v) anode/insulation layer having a thickness of 2 nm or less/hole transporting layer/light emitting layer/insulation layer having a thickness of 2 nm or less/cathode
w) anode/insulation layer having a thickness of 2 nm or less/light emitting layer/electron transporting layer/cathode
x) anode/light emitting layer/electron transporting layer/insulation layer having a thickness of 2 nm or less/cathode
y) anode/insulation layer having a thickness of 2 nm or less/light emitting layer/electron transporting layer/insulation layer having a thickness of 2 nm or less/cathode
z) anode/insulation layer having a thickness of 2 nm or less/hole transporting layer/light emitting layer/electron transporting layer/cathode
aa) anode/hole transporting layer/light emitting layer/electron transporting layer/insulation layer having a thickness of 2 nm or less/cathode
ab) anode/insulation layer having-a thickness of 2 nm or less/hole transporting layer/light emitting layer/electron transporting layer/insulation layer having a thickness of 2 nm or less/cathode

The polymer LED of the present invention includes device structures exemplified in the above a) to ab) in which a polymer compound of the present invention is contained in any one of a hole injection layer, hole transporting layer, light emitting layer, electron transporting layer and electron injection layer.

The substrate forming a polymer LED of the present invention may advantageously be a substrate which forms an electrode and does not vary in forming a layer of an organic substance, and examples thereof include glass, plastic, polymer films, silicon substrates and the like. In the case of an opaque substrate, it is preferable that the opposite electrode is transparent or semi-transparent.

Usually, at least one of an anode and a cathode in a polymer LED of the present invention is transparent or semi-transparent.It is preferable that the anode side is transparent or semi-transparent.

As the material of the anode, electrically conductive metal oxide films, semi-transparent metal films and the like are used. Specifically, films (NESA and the like) formed using an electrically conductive glass composed of indium oxide, zinc oxide, tin oxide, and their composites indium·tin·oxide (ITO), indium·zinc·oxide and the like, and gold, platinum, silver, copper and the like are used, and preferable are ITO, indium·zinc·oxide and tin oxide. As the production method, a vacuum vapor deposition method, sputtering method, ion plating method, plating method and the like are mentioned. As the anode, organic transparent conductive films of polyaniline or its derivatives, polythiophene or its derivatives, and the like may be used.

The thickness of an anode can be appropriately selected in view of light transmission and electric conductivity, and for example, 10 nm to 10 µm, preferably 20 nm to 1 µm, further preferably 50 nm to 500 nm.

For making charge injection easy, a layer composed of a phthalocyanine derivative, electrically conductive polymer, carbon and the like, or a layer having an average thickness of 2 nm or less composed of a metal oxide, metal fluoride, organic insulation material or the like may be provided on an anode.

As the material of a cathode used in a polymer LED of the present invention, materials of small work function are preferable. For examples, metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and the like, alloys composed of two or more of then, or alloys composed of at least one of them and at least one of gold, silver, platinum, copper, manganese, titanium, cobalt, nickel, tungsten and tin, and graphite or graphite intercalation compounds, and the like are used. As examples of the alloy, magnesium-silver alloy, magnesium-indium alloy, magnesium-aluminum alloy, indium-silver alloy, lithium-aluminum alloy, lithium-magnesium alloy, lithium-indium alloy, calcium-aluminum alloy, and the like are mentioned. The cathode may have a lamination structure composed of two or more layers.

The thickness of the cathode can be appropriately selected in view of electric conductivity and durability, and for example, 10 nm to 10 µm, preferably 20 nm to 1 µm, further preferably 50 nm to 500 nm.

As the method of producing a cathode, a vacuum vapor deposition method, sputtering method, lamination method of thermally press-bonding a metal film, and the like are used. Between a cathode and an organic substance layer, a layer composed of an electrically conductive polymer, or a layer having an average thickness of 2 nm or less composed of a metal oxide, metal fluoride, organic insulation material or the like may be provided. After producing a cathode, a protective layer may be installed for protecting the polymer LED. For using the polymer LED stably for a long period of time, it is preferable to install a protective layer and/or protective cover for protecting the device from outer environments.

As the protective layer, polymer compounds, metal oxides, metal fluorides, metal borides and the like can be used. As the protective cover, a glass plate, a plastic plate having a surface subjected to treatment for lowering water permeability, and the like can be used, and a method of sealing by pasting the cover to a device substrate with a thermo-setting resin or photo-curing resin is suitably used. When a space is maintained using a spacer, prevention of scaring of a device is easy. When the space is filled with an inert gas such as nitrogen and argon, oxidation of a cathode can be prevented. Further, by placing a drier such as barium oxide and the like in the space, imparting damage to a device by moisture adsorbed in the production process is suppressed easily. Of them, any one or more means are preferably adopted.

The polymer LED of the present invention can be used as back light of a sheet light source, segment display, dot matrix display and liquid crystal display.

For obtaining light emission in the form of sheet using a polymer LED of the present invention, a sheet anode and a sheet cathode may be advantageously placed so as to overlap. For obtaining light emission in the form of pattern, there are a method in which a mask equipped with windows in the form of pattern is placed on the surface of the above light emitting device in the form of sheet, a method in which an organic substance layer at a non-light emitting part is formed with extremely large thickness to establish substantially no-light emission, a method in which either an anode or a cathode, or both electrodes are formed in the form of pattern. By forming a pattern by any of these methods and placing several electrodes so that on/off can be switched independently, a display device of segment type capable of displaying numbers and letters, and simple marks and the like is obtained. Further, for obtaining a dot matrix device, it may be advantageous that both of an anode and a cathode are formed in the form of stripe and placed so as to cross. By a method of separately painting a plurality of light emitting materials of different emitting colors or a method of using a color filter or fluorescence exchange filter, it becomes possible to attain partial color display or multi-color display. The dot matrix device may be passively driven or actively driven in combination with TFT and the like. These displays can be used as a display of computers, televisions, portable terminals, portable telephones, car navigations, video camera view finders and the like.

The above light emitting device in the form of sheet is of self emitting thin type, and can be suitably used as a sheet light source for back light of a liquid crystal display, or a sheet light source for illumination. If a flexible substrate is used, it can also be used as a light source or display in the form of curved surface.

As the organic transistor, a polymer electric field effect transistor is mentioned.

Regarding the structure of the polymer electric field effect transistor, usually, a source electrode and a drain electrode are provided adjacently to an active layer composed of a polymer, further, a gate electrode may be advantageously provided sandwiching an insulation layer adjacent to the active layer.

The polymer electric field effect transistor is usually formed on a supporting substrate. The material of the supporting substrate is not particularly restricted providing it does not disturb a property as an electric field effect transistor, and also a glass substrate, flexible film substrate and plastic substrate can be used.

The polymer electric field effect transistor can be produced by known methods, for example, a method described in JP-A No. 5-110069.

Use of a polymer which is soluble in an organic solvent in forming an active layer is very advantageous and preferable for production. As a method for film formation from a solution containing a polymer dissolved in an organic solvent, application methods such as a spin coat method, casting method, micro gravure coat method, gravure coat method, bar coat method, role coat method, wire bar coat method, dip coat method, spray coat method, screen printing method, flexo printing method, offset printing method, inkjet printing method and the like can be used.

Preferable is an sealed polymer electric field effect transistor obtained by producing a polymer electric field effect transistor, then, sealing the transistor. By this, the polymer electric field effect transistor is shielded off from atmospheric air, and lowering of a property of the polymer electric field effect transistor can be suppressed.

As the sealing method, mentioned are a method of covering with an UV hardening resin, thermo-setting resin, inorganic SiONx film and the like, a method of pasting a glass plate or film with an UV hardening resin, thermo-setting resin and the like. For carrying out shielding off from atmospheric air effectively, it is preferable to perform a process after production of a polymer electric field effect transistor until sealing, without exposing to atmospheric air (for example, in dried nitrogen atmosphere, vacuum, and the like).

The present invention will be illustrated further in detail by the following examples.

Here, regarding the number-average molecular weight and weight-average molecular weight, a polystyrene-reduced number-average molecular weight and weight-average molecular weight were measured by SEC (LC-10Avp: manufactured by Shimadzu Corp.). A polymer to be measured was injected in an amount of 50 µL at a concentration of about 0.5 wt%. A mobile phase was allowed to flow at a flow rate of 0.6 mL/min using chloroform or tetrahydrofuran (THF). Column: two TSKgel SuperHM-H (Tosoh Corp.) and one TSKgel SuperH2000 (Tosoh Corp.) were connected serially. As the detector, a differential refractive index detector (RID-10A: manufactured by Shimadzu Corp.) was used. Synthesis Example 1 (synthesis of compound A)

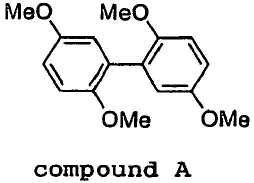

Into a three-necked flask was charged 2,5-dimethoxyphenylboric acid (20.1 g), 1-bromo-2,5-dimethoxybenzene (20.0 g), potassium carbonate (31.8 g), toluene (114 ml) and water (114 ml) under an inert atmosphere, and deaerated for 30 minutes with an argon gas. Palladium tetrakis(triphenylphosphine) (0.53g) was charged under argon flow, and the mixture was heated up to 100QC in an oil bath and reacted for 12 hours. After completion of the reaction, the temperature was returned to room temperature, a toluene layer was washed with water, and a toluene solution was passed through a short column of silica gel to remove the Pd catalyst, then, the solvent was distilled off, to obtain an intended substance (yield amount: 19.3 g, yield: 76%).
¹H-NMR (300 MHz/CDCl₃) :
δ 3.73 (s, 6H), 3. 78 (s, 6H), 6. 8~6. 9 (m, 6 H)

### Synthesis Example 2 (synthesis of compound B)

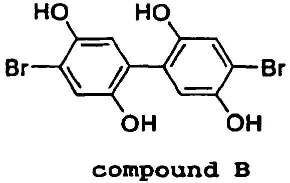

Into a three-necked flask under an inert atmosphere was charged compound A (19.3 g) and dissolved in de-hydrated N, N-dimethylformamide (270 ml) . While cooling the flask in an ice bath, N-chlorosuccinimide (25.0 g) in dye-hydrated N,N-dimethylformamide (80 ml) was dropped over 15 minutes from a dropping funnel. After completion of dropping, the temperature was returned to room temperature slowly while gently stirring, and stirred for one day.

To the reaction solution was added water (2000 ml), and the deposited precipitate was recovered by filtration. The resultant precipitate was re-crystallized from toluene/hexane, to obtain 15.6 g of a white crystal.

The resultant white crystal was placed in a three-necked flask under an inert atmosphere, and dissolved in de-hydrated methylene chloride (300 ml). While cooling the flask in an ice bath, a methylene chloride solution (1 mol/L, 150 ml) of boron tribromide was charged over 1 hour using a dropping funnel. After completion of dropping, the temperature was returned slowly to room temperature while stirring, and stirred overnight.

Extraction from the reaction solution was performed with ethyl acetate, an organic layer was washed with water, then, the solvent was distilled off to obtain an intended substance (yield amount: 15.8 g).
¹H-NMR (300MHz/CDCl₃) :
δ 6. 7 4 (s, 2 H), 6. 9 7 (s, 2H), 8. 9 7 (s, 2H), 9. 4 5 (s, 2 H)

### Synthesis Example 3 (synthesis of compound C)

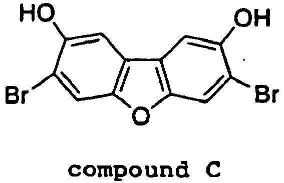

Into a flask under an inert atmosphere was added compound B (100 g), zeolite (26.6 g, Zeolite HSZ-371 NHA (Tosoh), type Y zeolite, pore size 8.5 A, cation species: NH₄⁺), and o-dichlorobenzene (2850 ml) dried over molecular sieves. The mixture was stirred while heating in an oil bath (bath temperature 180ºC × 16 hours). The product contained an intended substance as a main product. The production amount of the intended substance was about 70% according to LC percentage, and the production amount of an isomer was at most 5% or less. The product was cooled down to around 80ºC, and ethyl acetate was added and zeolite was filtrated off. Extraction with heated ethyl acetate was further performed from the filtrated zeolite, to filtrate off the zeolite. The filtrates were combined and the solvent was distilled off, then, re-crystallization from toluene/ethyl acetate was performed to obtain an intended substance (yield amount: 56.1 g).
MS spectrum: [M-H]⁻ 356.9

### Synthesis Example 4 (synthesis of compound D)

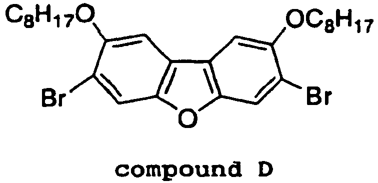

Into a three-necked flask under an inert atmosphere was placed compound C (2.1 g) and potassium carbonate (2.0 g) , and 1-bromooctane (2.4 g) and dimethylformamide (190 ml) were charged, and the mixture was heated up to 160ºC and reacted for 6 hours. After completion of the reaction, the temperature was returned to room temperature, water was added, then, extraction with ethyl acetate was carried out, water washing was performed, and the solvent was distilled off. Purification by silica gel chromatography was performed to obtain an intended substance (yield amount: 1.6 g).
¹H-NMR (300MHz/CDCl₃) : δ0. 90 (t, 6H), 1. 26~1. 9 5 (m, 24H), 4. 11 (t, 4H), 7. 34 (s, 2H), 7. 74 (s, 2H)

### Synthesis Example 5

### <Synthesis of polymer compound 1>

2,7-dibromo-9,9-dioctylfluorene (26 g, 0.047 mol), 2,7-dibromo-9,9-diisopentylfluorene (5.6 g, 0.012 mol) and 2,2'-bipyridyl (22 g, 0.141 mol) were dissolved in 1600 mL of de-hydrated tetrahydrofuran, then, an atmosphere in the system was purged with nitrogen by bubbling with nitrogen. Under a nitrogen atmosphere, to this solution was added bis(1,5-cyclooctadiene)nickel(0){Ni(COD)₂} (40 g. 0.15 mol) and the mixture was heated up to 60ºC, and reacted for 8 hours. After reaction, this reaction solution was cooled down to room temperature (about 25ºC), dropped into 25% ammonia water 20 mL/methanol 1200 mL/ion exchanged water 1200 mL mixed solution and the mixture was stirred for 30 minutes, then, the deposited precipitate was filtrated and air-dried. Then, the dried precipitate was dissolved in 1100 mL of toluene and filtrated, and the filtrate was dropped into 3300 mL of methanol and stirred for 30 minutes. The deposited precipitate was filtrated, and washed with 1000 mL of methanol, then, dried under reduced pressure for 5 hours. The yield of the resulting copolymer was 20 g (hereinafter, referred to as polymer compound 1) . Polymer compound 1 had a polystyrene-reduced average molecular weight and weight-average molecular weight of Mn=9.9×10⁴ and Mw=2.0×10⁵, respectively (mobile phase: tetrahydrofuran).

### Synthesis Example 6

### <Synthesis of polymer compound 2>

2,7-dibromo-9,9-dioctylfluorene (5.8 g, 0.0105 mol), N,N'-bis(4-bromophenyl)-N,N'-bis(4-n-butylphenyl)-1,4-pheny lenediamine (3.1 g, 0.0045 mol) and 2,2'-bipyridyl (6.6 g) were dissolved in 500 mL of de-hydrated tetrahydrofuran, then, an atmosphere in the system was purged with nitrogen by bubbling with nitrogen. Under a nitrogen atmosphere, to this solution was added bis(1,5-cyclooctadiene)nickel(0)(Ni(COD)₂} (12.0 g) and the mixture was heated up to 60ºC , and reacted for 3 hours while stirring. After reaction, this reaction solution was cooled down to room temperature (about 25ºC), dropped into 25% ammonia water 50 mL/methanol about 200 mL/ion exchanged water about 300 mL mixed solution and the mixture was stirred for 1 hour, then, the deposited precipitate was filtrated and air-dried, and dissolved in about 500 mL of toluene. Thereafter, about 300 mL of 1 N hydrochloric acid was added and the mixture was stirred for 1 hour, an aqueous layer was removed, and about 300 mL of 4% ammonia water was added to an organic layer, and stirred for 1 hour, then, an aqueous layer was removed. About 300 mL of ion exchanged water was added to an organic layer, and stirred, then, an aqueous layer was removed. The organic layer was dropped into about 700 mL of methanol and stirred for 1 hour, the deposited precipitate was filtrated and dried under reduced pressure for 2 hours. and dissolved in about 350 mL of toluene. Thereafter, purification was performed through an alumina column, the recovered toluene solution was dropped into about 700 mL of methanol and stirred for 1 hour, the deposited precipitate was filtrated and dried under reduced pressure for 2 hours. The resultant copolymer (hereinafter, referred to as polymer compound 2) showed a yield of 3.5 g. The polystyrene-reduced number-average molecular weight and weight-average molecular weight were Mn=3.7×10⁴ and Mw=2.8×10⁵, respectively (mobile phase: chloroform).

### Example 1

### <synthesis of 4-t-butyl-2,6-dimethylbromobenzene>

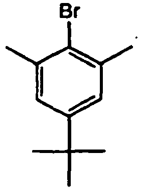

Under an inert atmosphere, 225 g of acetic acid was charged into a 500 ml three-necked flask, and 24.3 g of 5-t-butyl-m-xylene was added. Subsequently, 31.2 g of bromine was added, then, the mixture was reacted at 15 to 20ºC for 3 hours.

The reaction solution was added to 500 ml of water and the deposited precipitate was filtrated. The precipitate was washed with 250 ml of water twice, to obtain 34.2 g of white solid.
¹H-NMR (300MHz/CDCl₃):
δ(ppm) = 1. 3 (s, 9H), 2. 4 (s, 6H), 7. 1 (s, 2H) MS (FD+) M+ 241

### <Synthesis of N,N'-diphenyl-N,N'-bis(4-t-butyl-2,6-dimethylphenyl)-1,4-ph enylenediamine>

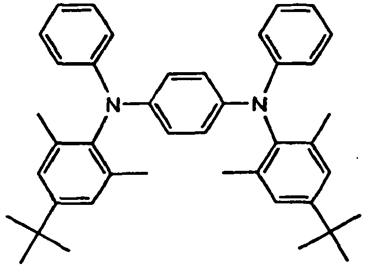

Under an inert atmosphere, 36 ml of deaerated de-hydrated toluene was charged into a 100 ml three-necked flask, and 0.63 g of tri(t-butyl)phosphine was added. Subsequently, 0.41 g of tris(dibenzylideneacetone)dipalladium, 9.6 g of the above 4-t-butyl-2,6-dimethylbromobenzene, 5.2 g of t-butoxysodium and 4.7 g of N,N'-diphenyl-1,4-phenylenediamine were added, then, reacted at 100ºC for 3 hours. The reaction solution was added to 300 ml of saturated brine, and extracted with 300 ml of chloroform warmed at about 50ºC. The solvent was distilled off, then, 100 ml of toluene was added, the mixture was heated until dissolution of solid, and allowed to cool, then, the precipitate was filtrated, to obtain 9.9 g of white solid.

### <Synthesis of N,N'-bis(4-bromophenyl)-N,N'-bis(4-t-butyl-2,6-dimethylphen yl)-1,4-phenylenediamine>

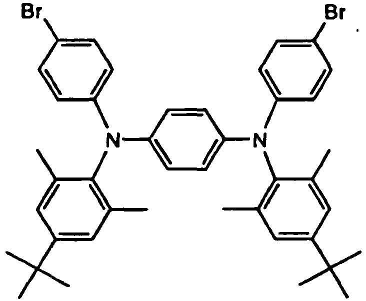

Under an inert atmosphere, 350 ml of de-hydrated N,N-dimethylformamide was charged into a 1000 ml of three-necked flask, and 5.2 g of the above N,N'-diphenyl-N,N'-bis(4-t-butyl-2,6-dimethylphenyl)-1,4-ph enylenediamine was dissolved, then, N-bromosuccinimide 3.5 g/N,N-dimethylformamide solution was dropped while cooling in an ice bath, and reacted over night and day.

To the reaction solution was added 150 ml of water, the deposited precipitate was filtrated, and washed with 50 ml of methanol twice, to obtain 4.4 g of white solid.
¹H-NMR (300MHz/THF-d8):
δ (ppm) = 1. 3 [s, 18H], 2. 0 [s, 12H], 6. 6~6. 7 [d, 4H], 6. 8~6. 9 [br, 4H], 7. 1 [s, 4H], 7. 2~7. 3 [d, 4H]
MS (FD+) M+ 738

### <Synthesis of polymer compound 3>

The above compound D (2.65 g, 4.6 mmol), the above N,N'-bis(4-bromophenyl)-N,N'-bis(4-t-butyl-2,6-dimethylphen yl)-1,4-phenylenediamine (1.44 g, 2.0 mmol) and 2,2'-bipyridyl (2.31 g, 15 mmol) were dissolved in 400 ml of de-hydrated tetrahydrofuran, then, an atmosphere in the system was purged with nitrogen by bubbling with nitrogen. Under a nitrogen atmosphere, to this solution was added bis(1,5-cyclooctadiene)nickel(0){Ni(COD)₂} (4.18 g, 15 mmol) and the mixture was heated up to 60ºC, and reacted for 3 hours while stirring. After reaction, this reaction solution was cooled down to room temperature (about 25ºC) , dropped into 25% ammonia water 90 mL/methanol 900 mL/ion exchanged water 450 mL mixed solution and the mixture was stirred for 1 hour, then, the deposited precipitate was filtrated and dried under reduced pressure for 2 hours, and dissolved in 300 mL of toluene. Then, 300 mL of 1 N hydrochloric acid was added and the mixture was stirred for 1 hour, an aqueous layer was removed, 300 mL of 4% ammonia water was added to an organic layer, and the mixture was stirred for 1 hour, then, an aqueous layer was removed. An organic layer was dropped into 1800 mL of methanol and stirred for 1 hour, the deposited precipitate was filtrated and dried under reduced pressure for 2 hours, and dissolved in 300 mL of toluene. Thereafter, purification was performed through an alumina column (alumina amount: 90 g) , and the recovered toluene solution was dropped into 2200 mL of methanol and stirred for 1 hour, and the deposited precipitate was filtrated and dried under reduced pressure for 2 hours. The resulting copolymer (hereinafter, referred to as polymer compound 3) showed a yield of 1.4 g. The polystyrene-reduced number-average molecular weight was Mn=2.8×10⁴, and Mw=1.1×10⁵ (moving bed: tetrahydrofuran).

### Example 2

On a glass substrate carrying an ITO film having a thickness of 150 nm formed by a sputtering method, a film was formed by spin coat with a thickness of 70 nm using a solution of poly(ethylenedioxythiophene)/polystyrenesulfonic acid (Beyer, BaytronP), and dried on a hot plate at 200ºC for 10 minutes. Next, a film was formed by spin coat at a revolution of 1100 rpm using a toluene solution so prepared that the concentration of a 3:7 (weight ratio) mixture of polymer compound 3 and polymer compound 1 was 1.0 wt%. Further, this was dried at 80ºC for 1 hour under reduced pressure, then, lithium fluoride was vapor-deposited at a thickness of about 4 nm to give a cathode, and calcium was vapor-deposited at a thickness of about 5 nm, then, aluminum was vapor-deposited at a thickness of about 35 nm, producing an EL device. After the degree of vacuum reached 1×10⁻⁴ Pa or less, vapor-deposition of a metal was initiated.

By applying voltage on the resulting device, EL light emission having a peak at 468 nm was obtained. The maximum value of light emission efficiency was 3.1 cd/A. The initial luminance was set at 625 cd/m², and attenuation of luminance was measured to find a luminance after 20 hours of 427 cd/m².

### Comparative Example 1

A device was produced in the same manner as in Example 2 excepting that polymer compound 2 was used instead of polymer compound 3, and a film was formed by spin coat at a revolution of 1300 rpm of a 1.5 wt% toluene solution of a 3:7 (weight ratio) mixture of polymer compound 2 and polymer compound 1. By applying voltage on the resultant device, EL light emission having a peak at 464 nm was obtained. The maximum value of light emission efficiency was 1.8 cd/A. The initial luminance was set at 413 cd/m², and attenuation of luminance was measured to find a luminance after 20 hours of 207 cd/m².

### Reference Example 3

### <synthesis of N,N-diphenyl-N-(4-t-butyl-2,6-dimethylphenyl)-amine>

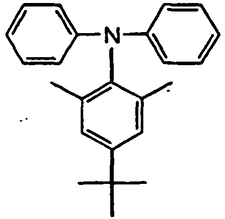

Under an inert atmosphere, 100 ml of deaerated de-hydrated toluene was placed into a 300 ml three-necked flask, and 16.9 g of diphenylamine and 25.3 g of 4-t-butyl-2,6-dimethylbromobenzene were added. Subsequently, 0.92 g of tris**(**dibenzylideneacetone**)**dipalladium and 12.0 g of t-butoxysodium were added, then, 1.01 g of tri(t-butyl)phosphine was added. Thereafter, the mixture was reacted at 100ºC for 7 hours.

The reaction solution was poured into saturated brine, and extracted with 100 ml of toluene. The toluene layer was washed with dilute hydrochloric acid and saturated brine, then, the solvent was distilled off to obtain black solid. This was separated and purified by silica gel column chromatography (hexane/chloroform = 9/1), to obtain 30.1 g of white solid. ¹H-NMR (300MHz/CDCl₃) : δ (ppm) =1. 3 (s, 9H), 2. 0 (s, 6H), 6. 8~7. 3 (m, 10H)

### <synthesis of N,N-bis(4-bromophenyl)-N-(4-t-butyl-2,6-dimethylphenyl)-ami ne>

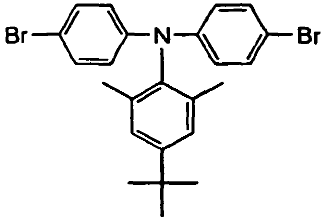

Under an inert atmosphere, 333 ml of de-hydrated N,N-dimethylformamide and 166 ml of hexane were placed into a 1000 ml three-necked flask, and 29.7 g of the above N,N-diphenyl-N-(4-t-butyl-2,6-dimethylphenyl)-amine was dissolved, then, 100 ml of N-bromosuccinimide 33.6 g/N,N-dimethylformamide solution was dropped under shading and ice bath, and reacted over night and day.

The reaction solution was concentrated under reduced pressure to 200 ml, and added into 1000 ml of water, and the deposited precipitate was filtrated. Further, the resulting crystal was re-crystallized twice from DMF/ethanol, to obtain 23.4 g of white solid.
¹H-NMR (300MHz/CDCl₃) :
δ(ppm) = 1. 3 (s. 9H), 2. 0 (s, 6H), 6. 8 (d, 2H), 7.1 (s, 2H), 7.3 (d, 2H),
MS (APCI I (+)):M+ 488

### Example 4

4.08 g of the above compound D, 1.45 g of N,N'-bis(4-bromophenyl)-N-(4-t-butyl-2,6-dimethylphenyl)-am ine and 4.4 g of 2,2'-bipyridyl were charged into a reaction vessel, then, an atmosphere in the reaction system was purged with a nitrogen gas. To this system was added 350 ml of tetrahydrofuran through which an argon gas was bubbled previously. Next, to this mixed solution was added 7.7 g of bis(1,5-cyclooctadiene)nickel(0), and reacted at 60ºC for 3 hours. The reaction was conducted in a nitrogen gas atmosphere. After reaction, this solution was cooled, then, poured into 25% ammonia water 40 ml/methanol 200 ml/ion exchanged water 200 ml mixed solution, and stirred for about 1 hour. Then, the produced precipitate was recovered by filtration. This precipitate was washed with methanol, then, dried under reduced pressure for 2 hours. Then, this precipitate was dissolved in 100 mL of toluene, the undissolved residue was removed by filter paper, and passed through an alumina column (alumina amount: 20 g). Thereafter, 100 mL of 1 N hydrochloric acid was added and the mixture was stirred for 1 hour, an aqueous layer was removed and 100 mL of 4% ammonia water was added to an organic layer and stirred for 1 hour, then, an aqueous layer was removed, further 100 mL of water was added and stirred for 1 hour, then, an aqueous layer was removed. An organic layer was dropped into 200 mL of methanol and stirred for 1 hour, the deposited precipitate was filtrated and dried under reduced pressure for 2 hours. The resultant polymer compound is called polymer compound 4. The yield amount was 1.7 g.

The polystyrene-reduced number-average molecular weight was 4.5×10⁴ and the polystyrene-reduced weight-average molecular weight was 1.2×10⁵ (mobile phase: tetrahydrofuran). Synthesis Example 7

0.60 g (1.0 mmol) of the above compound D, 0.20 g (0.44 mmol) of N,N'-bis(4-bromophenyl)-N-(4-isobutylphenyl)-amine and 0.50 g (3.2 mmol) of 2,2'-bipyridyl were charged into a reaction vessel, then, an atmosphere in the reaction system was purged with a nitrogen gas. To this system was added 40 ml of tetrahydrofuran deaerated previously by bubbling with an argon gas (de-hydrated solvent). Next, to this mixed solution was added 0.90 g (3.2 mmol) of bis(1,5-cyclooctadiene)nickel(0), and reacted at 60ºC for 3 hours. The reaction was conducted in a nitrogen gas atmosphere. After reaction, this solution was cooled, then, poured into 25% ammonia water 10 ml/methanol 120 ml/ion exchanged water 50 ml mixed solution, and stirred for about 1 hour. Then, the produced precipitate was recovered by filtration. This precipitate was washed with methanol, then, dried under reduced pressure for 2 hours. Then, this precipitate was dissolved in 50 mL of toluene, 50 mL of 1 N hydrochloric acid was added and the mixture was stirred for 1 hour, an aqueous layer was removed and 50 mL of 4% ammonia water was added to an organic layer and stirred for 1 hour, then, an aqueous layer was removed. An organic layer was dropped into 120 mL of methanol and stirred for 1 hour, the deposited precipitate was filtrated and dried under reduced pressure for 2 hours, and dissolved in 30 mL of toluene. Thereafter, purification was carried out through an aluminum column (alumina amount: 20 g), and recovered toluene solution was dropped into 100 mL of methanol and stirred for 1 hour, and the deposited precipitate was filtrated and dried under reduced pressure for 2 hours. The resulting polymer compound is called polymer compound 5. The yield amount was 0.35 g.

The polystyrene-reduced number-average molecular weight was 4.3×10⁴ and the polystyrene-reduced weight-average molecular weight was 1.4×10⁵ (mobile phase: tetrahydrofuran).

### Example 5

On a glass substrate carrying an ITO film having a thickness of 150 nm formed by a sputtering method, a film was formed by spin coat with a thickness of 70 nm using a solution of poly(ethylenedioxythiophene)/polystyrenesulfonic acid (Beyer, BaytronP), and dried on a hot plate at 200ºC for 10 minutes. Next, a film was formed by spin coat at a revolution of 1000 rpm using a toluene solution so prepared that the concentration of a 3: 7 (weight ratio) mixture of polymer compound 4 and polymer compound 1 was 1.0 wt%. Further, this was dried at 80ºC for 1 hour under reduced pressure, then, lithium fluoride was vapor-deposited at a thickness of about 4 nm to give a cathode, and calcium was vapor-deposited at a thickness of about 5 nm, then, aluminum was vapor-deposited at a thickness of about 35 nm, producing an EL device. After the degree of vacuum reached 1×10⁻⁴ Pa or less, vapor-deposition of a metal was initiated.

By applying voltage on the resulting device, EL light emission having a peak at 452 nm was obtained. The maximum value of light emission efficiency was 2.4 cd/A. The initial luminance was set at 300 cd/m², and attenuation of luminance was measured to find a luminance after 5 hours of 174 cd/m².

### Comparative Example 2

A device was produced in the same manner as in Example 5 excepting that polymer compound 5 was used instead of polymer compound 4, and a film was formed by spin coat at a revolution of 1000 rpm of a 1.5 wt% toluene solution of a 3: 7 (weight ratio) mixture of polymer compound 5 and polymer compound 1.

By applying voltage on the resultant device, EL light emission having a peak at 448 nm was obtained. The maximum value of light emission efficiency was 2.4 cd/A. The initial luminance was set at 300 cd/m², and attenuation of luminance was measured to find a luminance after 5 hours of 145 **cd/m².** Synthesis Example 7

### <synthesis of compound E>

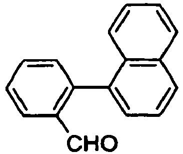

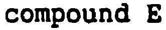

Under an inert atmosphere, into a 300 mL three-necked flask was placed 5.00 g (29 mmol) of 1-naphthaleneboronic acid, 6.46 g (35 mmol) of 2-bromobenzaldehyde, 10.0 g (73 mmol) of potassium carbonate, 36 ml of toluene and 36 ml of ion exchanged water, and bubbling with argon was performed for 20 minutes while stirring the mixture at room temperature. Subsequently, 16.8 mg (0.15 mmol) was tetrakis(triphenylphosphine)palladium was placed, further, bubbling with argon was performed for 10 minutes while stirring the mixture at room temperature. The temperature was raised up to 100ºC, and the mixture was reacted for 25 hours. After cooling to room temperature, an organic layer was extrated with toluene, and dried over sodium sulfate, then, the solvent was distilled off.

Purification by a silica gel column using a toluene:cyclohexane = 1:2 mixed solvent as a developing solution gave 5.18 g of compound E (yield: 86%) as white crystal.
¹H-NMR (300MHz/CDCl₃):
δ 7. 39~7. 6 2 (m, 5H), 7. 7 0 (m, 2H), 7. 94 (d, 2H), 8. 12 (dd, 2H). 9. 6 3 (s, 1H)
MS (APCI (+)) : (M+H) + 2 3 3

### <synthesis of compound F>

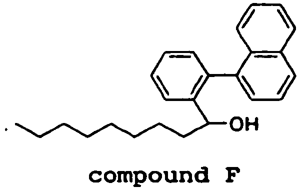

Under an inert atmosphere, into a 300 mL three-necked flask was placed 8.00 g (34.4 mmol) of compound E and 46 mL of de-hydrated THF, and the mixture was cooled down to -78ºC. Subsequnetly, 52 mL of n-octyl magnesium bromide (1.0 mol/l THF solution) was dropped over 30 minute. After completion of dropping, the temperature was raised up to 0ºC, the mixture was stirred for 1 hour, then, the temperature was raised up to room temperature and the mixture was stirred for 45 minutes. 20 mL of 1 N hydrochloric acid was added in an ice bath to stop the reaction, an organic layer was extracted with ethyl acetate, and dried over sodium sulfate. The solvent was distilled off, then, purification by a silica gel column using a toluene:cyclohexane = 10:1 mixed solvent as a developing solution gave 7.64 g of compound F (yield: 64%) as pale yellow oil. In HPLC measurement, two peaks were observed, and in LC-MS measurement, the same mass number was obtained, thus, the produce was judged to be a mixture of isomers.

### <synthesis of compound G>

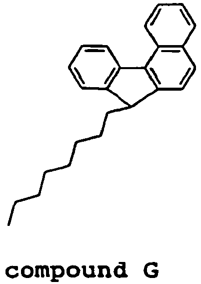

Under an inert atmosphere, into a 500 mL three-necked flask was placed 5.00 g (14.4 mmol) of compound F (mixture of isomers) and 74 mL of de-hydrated dichloromethane, and the mixture was stirred and dissolved at room temperature. Subsequnetly, an etherate complex of boron trifluoride was dropped at room temperature over 1 hour, and after completion of dropping, the mixture was stirred at room temperature for 4 hours. 125 ml of ethanol was added slowly while stirring, and when heat generation stopped, an organic layer was extracted with chloroform, and washed with water twice, and dried over magnesium sulfate. The solvent was distilled off, then, purification by a silica gel column using hexane as a developing solvent gave 3.22 g of compound G (yield: 68%) as colorless oil.
¹H-NMR (300MHz/CDCl₃):
δ0. 9 0 (t, 3H), 1. 03~1. 2 6 (m, 14H), 2. 13 (m, 2H), 4. 05 (t, 1H), 7. 3 5 (dd, 1H), 7. 46~7. 5 0 (m, 2H), 7. 59~ 7.65 (m, 3H), 7. 82 (d, 1H), 7. 9 4 (d, 1H), 8. 35 (d, 1H), 8.75 (d, 1 H)
MS (APCI (+)) : (M+H) + 3 2 9

### <synthesis of compound H>

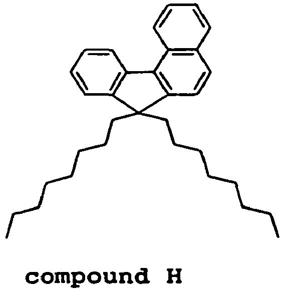

Under an inert atmosphere, into a 200 mL three-necked flask was placed 20 ml of ion exchanged water, and 18.9 g (0.47 mol) of sodium hydroxide was added portion-wise and dissolved while stirring. The aqueous solution was cooled to room temperature, then, 20 ml of toluene, 5.17 g (15.7 mmol) compound G and 1.52 g (4.72 mmol) of tributylammonium bromide were added and the temperature was raised up to 50ºC. n-octyl bromide was dropped, and after completion of dropping, the mixture was reacted at 50ºC for 9 hours. After completion of the reaction, an organic layer was extracted with toluene, washed with water twice, and dried over sodium sulfate. Purification by a silica gel column using hexane as a developing solvent gave 5.13 g of compound H (yield: 74%) as yellow oil.
¹H-NMR (300MHz/CDCl₃):
δ 0. 5 2 (m, 2H), 0. 79 (t, 6H), 1. 00~1. 20 (m, 22H), 2. 05 (t, 4H), 7. 34 (d, 1H), 7. 40~7. 53 (m. 2H), 7. 6 3 (m, 3H), 7. 83 (d, 1H), 7.94 (d, 1H), 8.31 (d, 1H), 8. 7 5 (d, 1H)
MS (A P C I (+)) : (M+H) + 441

### <synthesis of compound I>

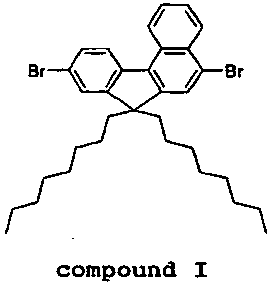

Under an air atmosphere, into a 50 mL three-necked flask was placed 4.00 g (9.08 mmol) of compound H and 57 ml of an acetic acid:dichloromethane = 1:1 mixed solvent, and the mixture was stirred and dissolved at room temperature. Subsequently, 7.79 g (20.0 mmol) of benzyltrimethylammonium tribromide was added and, zinc chloride was added until completion dissolution of benzyltrimethylammonium tribromide while stirring. The mixture was stirred for 20 hours at room temperature, then, 10 ml of a 5% sodium hydrogen sulfite aqueous solution was added to stop the reaction, an organic layer was extracted with chloroform, and washed with a potassium carbonate aqueous solution twice, and dried over sodium sulfate. Purification by flash column using hexane as a developing solvent was performed twice, then, re-crystallization was performed from ethano:hexane = 1:1, seqsequently from 10:1 mixed solvent, to obtain 4.13 g (yield: 76%) of compound I as white crystal.
¹H-NMR (300MHz/CDCl₃) :
δ 0. 6 0 (m, 2H), 0. 9 1 (t, 6H), 1. 0 1~1. 38 (m, 22H), 2. 09 (t, 4H), 7. 62~7. 7 5 (m, 3H), 7. 89 (s, 1H), 8. 2 0 (d, 1H), 8. 47 (d, 1H), 8. 7 2 (d, 1 H)
MS (AP P I (+)) : (M+H) + 5 9 8

### Synthesis Example 8

### <Synthesis of polymer compound 6>

Compound I (8.0 g, 0.015 mol) and 2,2'-bipyridyl (5.9 g, 0.038 mol) were dissolved in 300 mL of de-hydrated tetrahydrofuran, then, an atmosphere in the system was purged with nitrogen by bubbling with nitrogen. Under a nitrogen atmosphere, this solution was heated up to 60QC and bis(1,5-cyclooctadiene)nickel(0) (Ni(COD)₂} (10.4 g, 0.038 mmol) was added and reacted for 5 hours. After reaction, this reaction solution was cooled down to room temperature (about 25ºC), and dropped into 25% ammonia water 40 ml/methanol 300 ml/ion exchanged water 300 ml mixed solution, and stirred for 30 minutes, then, deposited precipitate was filtrated and air-dried. Then, the precipitate was dissolved in 400 mL of toluene and filtrated, and the filtrate was purified by passing through an alumina column, to this was added about 300 mL of 1 N hydrochloric acid and the mixture was stirred for 3 hours, an organic layer was removed, about 300 mL of 4% ammonia water was added to an organic layer and stirred for 2 hours, then, an aqueous layer was removed. About 300 mL of ion exchanged water was added to an organic layer and the mixture was stirred for 1 hour, then, an aqueous layer was removed. About 100 mL of methanol was dropped into an organic layer and stirred for 1 hour, the supernatant was removed by decantation. The resulting precipitate was dissolved in 100 mL of toluene, and dropped into about 200 mL of methanol and stirred for 1 hour, and filtrated and dried under reduced pressure for 2 hours. The resultant copolymer showed a yield of 4.1 g (hereinafter, referred to as polymer compound 6). Polymer compound 6 had a polystyrene-reduced average molecular weight and a weight-average molecular weight of Mn=1.5×10⁵ and Mw=2.7×10⁵, respectively (mobile phase: tetrahydrofuran).

### Synthesis Example 9

### <Synthesis of polymer compound 7>

Compound I (0.40 g), N,N-bis(4-bromophenyl)-N-(4-sec-butylphenyl)-amine (0.34 g) and 2,2'-bipyridyl (0.46 g) were dissolved in 50 mL of de-hydrated tetrahydrofuran, then, an atmosphere in the system was purged with nitrogen by bubbling with nitrogen. Under a nitrogen atmosphere, to this solution was added bis(1,5-cyclooctadiene)nickel(0) (Ni(COD)₂} (0.80 g) and the mixture was heated up to 60QC and reacted for 3 hours while stirring. After reaction, this reaction solution was cooled down to room temperature (about 25ºC), and dropped into 25% ammonia water 5 ml/methanol about 50 ml/ion exchanged water about 50 ml mixed solution, and stirred for 1 hour, then, the deposited precipitate was filtrated and dried under reduced pressure for 2 hours, then, dissolved in 50 mL of toluene and filtrated, and the filtrate was purified by passing through an alumina column, to this was added about 50 mL of 4% ammonia water, the mixture was stirred for 2 hours, then, an aqueous layer was removed. About 50 mL of ion exchanged water was added and stirred for 1 hour, then, an aqueous layer was removed. An organic laywer was dropped into about 100 ml of methanol and stirred for 1 hour, the deposited precipitate was filtrated and dried under reduced pressure for 2 hours. The resultant copolymer (hereinafter, referred to as polymer compound 7) showed a yield of 241 mg. The polystyrene-reduced number-average molecular weight and weight-average molecular weight were Mn=1.1×10⁴ and Mw=1.9×10⁴, respectively (mobile phase: tetrahydrofuran).

### Example 6

### <Synthesis of polymer compound 8>

Compound I (0.90 g), N,N-bis(4-bromophenyl)-N-(4-t-butyl-2,6-dimethylphenyl)-ami ne (0.62 g) and 2,2'-bipyridyl (1.1 g) were dissolved in 110 mL of de-hydrated tetrahydrofuran, then, an atmosphere in the system was purged with nitrogen by bubbling with nitrogen. Under a nitrogen atmosphere, to this solution was added bis(1,5-cyclooctadiene)nickel(0) {Ni(COD)₂} (2.0 g) and the mixture was heated up to 60ºC and reacted for 3 hours while stirring. After reaction, this reaction solution was cooled down to room temperature (about 25ºC), and dropped into 25% ammonia water 30 ml/methanol about 150 ml/ion exchanged water about 150 mL mixed solution, and stirred for 1 hour, then, the deposited precipitate was filtrated and dried under reduced pressure for 2 hours, then, dissolved in 50 mL of toluene and filtrated, and the filtrate was purified by passing through an alumina column, to this was added about 50 mL of 4% ammonia water, the mixture was stirred for 2 hours, then, an aqueous layer was removed. About 50 mL of ion exchanged water was added and stirred for 1 hour, then, an aqueous layer was removed. An organic laywer was dropped into about 100 ml of methanol and stirred for 1 hour, the deposited precipitate was filtrated and dried under reduced pressure for 2 hours. The resultant copolymer (hereinafter, referred to as polymer compound 8) showed a yield of 500 mg. The polystyrene-reduced number-average molecular weight and weight-average molecular weight were Mn=5.7×10⁴ and Mw=1.5×10⁴, respectively (mobile phase: tetrahydrofuran).

### Example 7

On a glass substrate carrying an ITO film having a thickness of 150 nm formed by a sputtering method, a film was formed with a thickness of 70 nm by spin coat using a solution of poly(ethylenedioxythiophene)/polystyrenesulfonic acid (Beyer, BaytronP), and dried on a hot plate at 200ºC for 10 minutes. Next, a film was formed by spin coat at a revolution of 1200 rpm using a toluene solution so prepared that the concentration of a 2:8 (weight ratio) mixture of polymer compound 8 and polymer compound 6 was 1.5 wt%. Further, this was dried at 90ºC for 1 hour under reduced pressure, then, lithium fluoride was vapor-deposited at a thickness of about 4 nm to give a cathode, and calcium was vapor-deposited at a thickness of about 5 nm, then, aluminum was vapor-deposited at a thickness of about 70 nm, producing an EL device. After the degree of vacuum reached 1×10⁻⁴ Pa or less, vapor-deposition of a metal was initiated.

By applying voltage on the resulting device, EL light emission having a peak at 456 nm was obtained. The initial luminance was set at 956 cd/m², and attenuation of luminance was measured to find a luminance after 20 hours of 603 cd/m². Comparative Example 3

A device was produced in the same manner as in Example 7 excepting that polymer compound 7 was used instead of polymer compound 8, and a film was formed by spin coat at a revolution of 1200 rpm of a 1. 5 wt% toluene solution of a 2:8 (weight ratio) mixture of polymer compound 7 and polymer compound 6.

By applying voltage on the resultant device, EL light emission having a peak at 456 nm was obtained. The initial luminance was set at 928 cd/m². and attenuation of luminance was measured to find a luminance after 20 hours of 369 cd/m².

### INDUSTRIAL APPLICABILITY

When the polymer compound of the present invention is used in a polymer LED, this polymer LED shows long life. Therefore, this polymer LED can be preferably used for apparatuses such as light sources in the form of curved surface or sheet for illumination or backlight of a liquid crystal display, display devices of segment type, dot matrix flat panel displays and the like.

## Claims

1. A polymer compound capable of emitting light comprising at least one repeating unit of the following formula (1) and at least one repeating unit selected from the following formulae (2-1) and (2-2) and having a polystyrene-reduced number-average molecular weight of 10³ to 10⁸ as determined by a size exclusion chromatographic technique as defined herein: 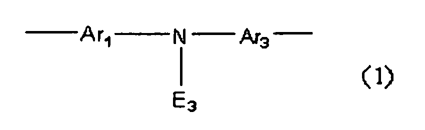 wherein, Ar₁ and Ar₃ represent each independently an arylene group or divalent heterocyclic group; E₃ represents a group of the following formula (3): 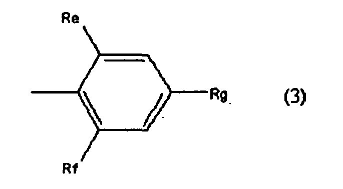 wherein, Re and Rf represent each independently an alkyl group having 3 or less carbon atoms, alkoxy group having 3 or less carbon atoms or alkylthio group having 3 or less carbon atoms and Rg represents an alkyl group having 3 to 20 carbon atoms, alkoxy group having 3 to 20 carbon atoms or alkylthio group having 3 to 20 carbon atoms; 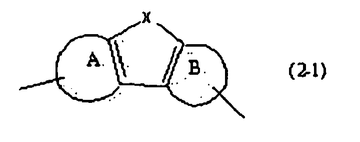 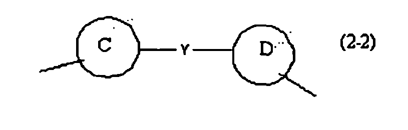 wherein, A ring, B ring, C ring and D ring represent each independently an aromatic ring; X represents -O-, -S-, -S(=O)-, -SO₂-, -C(R₁)(R₂)-, -B(R₃)-, -Si(R₄)(R₅)-, -P(R₆)-, -PR₇(=O)-, or -N(R₈)-; Y represents -CR₉=CR₁₀ or -C≡C-; R₁, R₂, R₃, R₄, R₅, R₆, R₇ and R₈ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, silyloxy group, substituted silyloxy group, monovalent heterocyclic group or halogen atom; and R₉ and R₁₀ represent each independently a hydrogen atom, alkyl group, aryl group, monovalent heterocyclic group, carboxyl group, substituted carboxyl group or cyano group;
and wherein, if the ratio of the mol number of a repeating unit of said formula (1) to the sum of mol numbers of all repeating units in the polymer compound is represented by x and if the ratio of the sum of mol numbers of repeating units represented by said formulae (2-1) and (2-2) to the sum of mol numbers of all repeating units is represented by y, then, 0.01 ≤x+y≤ 1.

2. The polymer compound according to claim 1, comprising at least one repeating unit of said formula (1) and at least one repeating unit selected from said formula (2-1).

3. The polymer compound according to claim 2, wherein X represents -C(R₁)(R₂)- and A ring and B ring represent a benzene ring in said formula (2-1).

4. The polymer compound according to claim 1, comprising at least one repeating unit of said formula (1) and at least one repeating unit selected from said formula (2-2).

5. The polymer compound according to any one of the preceding claims, wherein 0.01≤x/(x+y)≤0.99.

6. A composition comprising at least one material selected from hole transporting materials, electron transporting materials and light emitting materials, and at least one polymer compound according to any one of claims 1 to 5.

7. A solution comprising a polymer compound according to any one of claims 1 to 5.

8. The solution according to claim 7, comprising two or more organic solvents.

9. The solution according to claim 7 or 8, comprising an organic solvent having a structure containing at least one benzene ring and having a melting point of 0°C or less and a boiling point of 100°C or more.

10. The solution according to claim 7 or 8, comprising at least one organic solvent selected from anisole, xylene, cyclohexylbenzene and bicyclohexyl.

11. The solution according to any one of claims 7 to 10, wherein a solvent having the highest boiling point occupies 40 to 90 wt% of the total solvent weight.

12. The solution according to any one of claims 7 to 11, wherein the concentration of a polymer compound in the solution is 0.5 to 2.0 wt%.

13. The solution according to any one of claims 7 to 12, further comprising an additive for controlling viscosity and/or surface tension.

14. The solution according to any one of claims 7 to 13, further comprising an antioxidant.

15. A light emitting film comprising a polymer compound according to any one of claims 1 to 5.

16. An electrically conductive film comprising a polymer compound according to any one of claims 1 to 5.

17. The electrically conductive film according to claim 16, wherein the surface resistance is 1KΩ/□ or less.

18. An organic semiconductor film comprising a polymer compound according to any one of claims 1 to 5.

19. The organic semiconductor film according to claim 18, wherein the larger matter of electron mobility or hole mobility is 10⁻⁵ cm²/V/sec. or more.

20. An organic transistor having an organic semiconductor film according to claim 18 or 19.

21. A method of forming a film according to any one of claims 15 to 20, using an inkjet method.

22. A polymer light emitting device having a layer comprising a polymer compound according to any one of claims 1 to 5 between electrodes composed of an anode and a cathode.

23. The polymer light emitting device according to claim 22, wherein the layer comprising a polymer compound according to any one of claims 1 to 5 is a light emitting layer.

24. The polymer light emitting device according to claim 23, wherein the light emitting layer comprises further a hole transporting material, electron transporting material or light emitting material.

25. A sheet light source comprising a polymer light emitting device according to any one of claims 22 to 24.

26. A segment display comprising a polymer light emitting device according to any one of claims 22 to 24.

27. A dot matrix display comprising a polymer light emitting device according to any one of claims 22 to 24.

28. A liquid crystal display using a polymer light emitting device according to any one of claims 22 to 24 as back light.

## Patentansprüche

1. Eine Polymerverbindung, die zum Emittieren von Licht fähig ist, welche mindestens eine Wiederholungseinheit der folgenden Formel (1) und mindestens eine Wiederholungseinheit, ausgewählt aus den folgenden Formeln (2-1) und (2-2), umfasst und welche ein Polystyrol reduziertes Gewichtsmittel des Molekulargewichts von 10³ bis 10⁸, gemessen durch eine Größenausschlusschromatographie-Technik wie hierin definiert, aufweist: 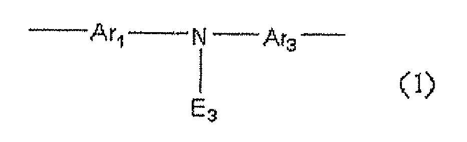 wobei Ar₁ und Ar₃ jeweils unabhängig einen Arylenrest oder einen zweiwertigen heterozyklischen Rest darstellen; E₃ einen Rest der folgenden Formel (3) darstellt: 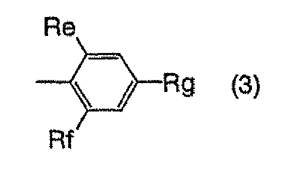 wobei Re und Rf jeweils unabhängig einen Alkylrest mit 3 oder weniger Kohlenstoffatomen, einen Alkoxyrest mit 3 oder weniger Kohlenstoffatomen oder einen Alkylthiorest mit 3 oder weniger Kohlenstoffatomen darstellen und Rg einen Alkylrest mit 3 bis 20 Kohlenstoffatomen, einen Alkoxyrest mit 3 bis 20 Kohlenstoffatomen oder einen Alkylthiorest mit 3 bis 20 Kohlenstoffatomen darstellt; 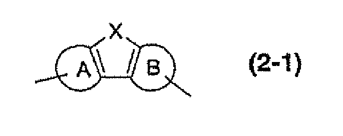 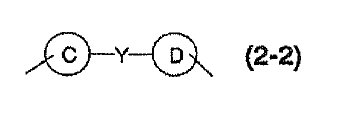 wobei Ring A, Ring B, Ring C und Ring D jeweils unabhängig einen aromatische Ring darstellen; X -O-, -S-, -S(=O)-, -SO₂-, -C(R₁)(R₂)-, -B(R₃)-, -Si(R₄)(R₅)-, -P(R₆)-, -PR₇(=O)- oder -N(R₈)- darstellt; Y -CR₉=CR₁₁₀ oder -C≡C- darstellt; R₁, R₂, R₃, R₄, R₅, R₆, R₇ und R₈ jeweils unabhängig einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, einen substituierten Aminorest, eine Silylgruppe, einen substituierten Silylrest, eine Silyloxygruppe, einen substituierten Silyloxyrest, einen einwertigen heterozyklischen Rest oder ein Halogenatom darstellen; und R₉ und R₁₀ jeweils unabhängig ein Wasserstoffatom, einen Alkylrest, einen Arylrest, einen einwertigen heterozyklischen Rest, eine Carbonylgruppe, einen substituierten Carboxylrest oder eine Cyanogruppe darstellen; und wobei, falls das Verhältnis der Molzahl einer Wiederholungseinheit der Formel (1) zu der Summe der Molzahlen aller Wiederholungseinheiten in der Polymerverbindung durch x dargestellt wird und falls das Verhältnis der Summe der Molzahlen der Wiederholungseinheiten, dargestellt durch Formeln (2-1) und (2-2), zu der Summe der Molzahlen aller Wiederholungseinheiten durch y dargestellt ist, dann 0,01≤x+y≤1 gilt.

2. Die Polymerverbindung gemäß Anspruch 1, die mindestens eine Wiederholungseinheit der Formel (1) und mindestens eine Wiederholungseinheit, ausgewählt aus der Formel (2-1), umfasst.

3. Die Polymerverbindung gemäß Anspruch 2, wobei X -C(R₁)(R₂)- darstellt und Ring A und Ring B einen Benzolring in der Formel (2-1) darstellen.

4. Die Polymerverbindung gemäß Anspruch 1, die mindestens eine Wiederholungseinheit der Formel (1) und mindestens eine Wiederholungseinheit, ausgewählt aus der Formel (2-2), umfasst.

5. Die Polymerverbindung gemäß einem der vorherigen Ansprüche, wobei 0,01 ≤ x/(x+y) ≤ 0.99 gilt.

6. Eine Zusammensetzung, die mindestens ein Material, ausgewählt aus Loch transportierenden Materialien, Elektronen transportierenden Materialien und Licht emittierenden Materialien, und mindestens eine Polymerverbindung gemäß einem der Ansprüche 1 bis 5 umfasst.

7. Eine Lösung, die eine Polymerverbindung gemäß einem der Ansprüche 1 bis 5 umfasst.

8. Die Lösung gemäß Anspruch 7, die zwei oder mehr organische Lösungsmittel umfasst.

9. Die Lösung gemäß Anspruch 7 oder 8, die mindestens ein organische Lösungsmittel umfasst, welches eine Struktur aufweist, die mindestens einen Benzolring enthält und einen Schmelzpunkt von 0°C oder niedriger und einen Siedepunkt von 100°C oder höher aufweist.

10. Die Lösung gemäß Anspruch 7 oder 8, welche mindestens ein organisches Lösungsmittel, ausgewählt aus Anisol, Xylol, Cyclohexylbenzol und Bicyclohexyl, umfasst.

11. Die Lösung gemäß einem der Ansprüche 7 bis 10, wobei ein Lösungsmittel, welches den höchsten Siedepunkt aufweist, 40 bis 90 Gew.-% des gesamten Lösungsmittelgewichts ausmacht.

12. Die Lösung gemäß einem der Ansprüche 7 bis 11, wobei die Konzentration einer Polymerverbindung in der Lösung 0,5 bis 2,0 Gew.-% beträgt.

13. Die Lösung gemäß einem der Ansprüche 7 bis 12, welche ferner einen Zusatzstoff zur Regelung der Viskosität und/oder Oberflächenspannung umfasst.

14. Die Lösung gemäß einem der Ansprüche 7 bis 13, welche ferner ein Antioxidationsmittel umfasst.

15. Eine Licht emittierende Folie, die eine Polymerverbindung gemäß einem der Ansprüche 1 bis 5 umfasst.

16. Eine elektrisch leitfähige Folie, die eine Polymerverbindung gemäß einem der Ansprüche 1 bis 5 umfasst.

17. Die elektrisch leitfähige Folie gemäß Anspruch 16, wobei der Oberflächenwiderstand 1 KΩ/□ oder weniger beträgt.

18. Eine organische Halbleiterfolie, welche eine Polymerverbindung gemäß einem der Ansprüche 1 bis 5 umfasst.

19. Die organische Halbleiterfolie gemäß Anspruch 18, wobei die größere Sache von Elektronenmobilität oder Lochmobilität 10⁻⁵ cm²/V/sek oder höher beträgt.

20. Ein organischer Transistor, welcher eine organische Halbleiterfolie gemäß Anspruch 18 oder 19 aufweist.

21. Ein Verfahren zur Herstellung einer Folie gemäß einem der Ansprüche 15 bis 20 unter Verwendung eines Tintenstrahlverfahrens.

22. Eine polymere, Licht emittierende Vorrichtung mit einer Schicht, welche eine Polymerverbindung gemäß einem der Ansprüche 1 bis 5 zwischen Elektroden, die aus einer Anode und einer Kathode bestehen, umfasst.

23. Die polymere, Licht emittierende Vorrichtung gemäß Anspruch 22, wobei die Schicht, welche eine Polymerverbindung gemäß einem der Ansprüche 1 bis 5 umfasst, eine Licht emittierende Schicht ist.

24. Die polymere, Licht emittierende Vorrichtung gemäß Anspruch 23, wobei die Licht emittierende Schicht ferner ein Loch transportierendes Material, Elektronen transportierendes Material oder Licht emittierendes Material umfasst.

25. Eine flächenartige Lichtquelle, die eine polymere, Licht emittierende Vorrichtung gemäß einem der Ansprüche 22 bis 24 umfasst.

26. Eine Segment-Anzeige, die eine polymere, Licht emittierende Vorrichtung gemäß einem der Ansprüche 22 bis 24 umfasst.

27. Eine Punktmatrixanzeige, die eine polymere, Licht emittierende Vorrichtung gemäß einem der Ansprüche 22 bis 24 umfasst.

28. Eine Flüssigkristallanzeige, die eine polymere, Licht emittierende Vorrichtung gemäß einem der Ansprüche 22 bis 24 als Hintergrundbeleuchtung verwendet.

## Revendications

1. Composé polymère capable d'émettre de la lumière comprenant au moins une unité répétitive de la formule (1) suivante et au moins une unité répétitive choisie parmi les formules (2-1) et (2-2) suivantes et présentant une masse moléculaire moyenne en nombre polystyrène-réduite de 10³ à 10⁸ comme déterminée par une technique chromatographique par exclusion de taille comme définie ici : 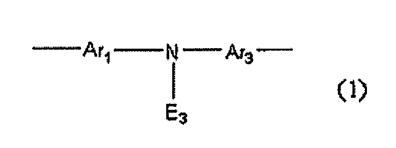 dans laquelle, Ar₁ et Ar₃ représentent chacun indépendamment un groupe arylène ou un groupe hétérocyclique divalent ; E₃ représente un groupe de la formule (3) suivante : 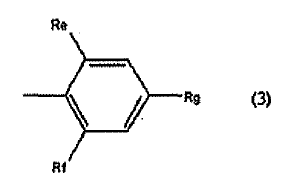 dans laquelle Re et Rf représentent chacun indépendamment un groupe alkyle ayant 3 atomes de carbone ou moins, un groupe alcoxy ayant 3 atomes de carbone ou moins ou un groupe alkylthio ayant 3 atomes de carbone ou moins et Rg représente un groupe alkyle ayant de 3 à 20 atomes de carbone, un groupe alcoxy ayant de 3 à 20 atomes de carbone ou un groupe alkylthio ayant de 3 à 20 atomes de carbone ; 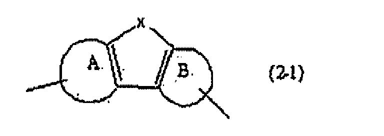 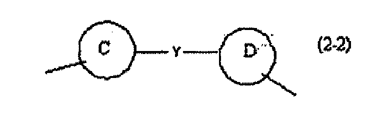 où le cycle A, le cycle B, le cycle C et le cycle D représentent chacun indépendamment un cycle aromatique ; X représente -0-, -S, - S(=O)-, -SO₂-, -C(R₁)(R₂)-, -B(R₃)-, -Si(R₄)(R₅)-, -P(R₆)-, -PR₇(=O)-, ou -N(R₈)- ; Y représente -CR₉=CR₁₀ ou -C≡C-; R₁, R₂, R₃, R₄, R₅, R₆, R₇ et R₈ représentent chacun indépendamment un groupe alkyle, un groupe alcoxy, un groupe alkylthio, un groupe aryle, un groupe aryloxy, un groupe arylthio, un groupe arylalkyle, un groupe arylalcoxy, un groupe arylalkylthio, un groupe arylalcényle, un groupe arylalcynyle, un groupe amino, un groupe amino substitué, un groupe silyle, un groupe silyle substitué, un groupe silyloxy, un groupe silyloxy substitué, un groupe hétérocyclique monovalent ou un atome d'halogène ; et R₉ et R₁₀ représentent chacun indépendamment un atome d'hydrogène, un groupe alkyle, un groupe aryle, un groupe hétérocyclique monovalent, un groupe carboxyle, un groupe carboxyle substitué ou un groupe cyano ; et dans lequel, si le rapport du nombre de moles de l'unité répétitive de ladite formule (1) à la somme du nombre de moles de toutes les unités répétitives dans le composé polymère est représentée par x et si le rapport de la somme du nombre de moles des unités répétitives représentées par lesdites formules (2-1) et (2-2) par rapport à la somme du nombre de moles de toutes les unités répétitives est représentée par y, alors, 0,01 ≤ x + y ≤ 1.

2. Composé polymère selon la revendication 1, comprenant au moins une unité répétitive de ladite formule (1) et au moins une unité répétitive choisie parmi ladite formule (2-1).

3. Composé polymère selon la revendication 2, dans lequel X représente -C(R₁)(R₂)- et le cycle A et le cycle B représentent un cycle benzène dans ladite formule (2-1).

4. Composé polymère selon la revendication 1, comprenant au moins une unité répétitive de ladite formule (1) et au moins une unité répétitive choisie parmi ladite formule (2-2).

5. Composé polymère selon l'une quelconque des revendications précédentes, dans lequel 0,01 ≤ x/ (x + y) ≤ 0,99.

6. Composition comprenant au moins un matériau choisi parmi des matériaux de transport de trous, des matériaux de transfert d'électrons et des matériaux émettant de la lumière, et au moins un composé polymère selon l'une quelconque des revendications 1 à 5.

7. Solution comprenant un composé polymère selon l'une quelconque des revendications 1 à 5.

8. Solution selon la revendication 7, comprenant deux ou plusieurs solvants organiques.

9. Solution selon la revendication 7 ou 8, comprenant un solvant organique ayant une structure contenant au moins un cycle benzène et ayant un point de fusion de 0°C ou inférieur et un point d'ébullition de 100°C ou supérieur.

10. Solution selon la revendication 7 ou 8, comprenant au moins un solvant organique choisie parmi l'anisole, le xylène, le cyclohexylbenzène et le bicyclohexyle.

11. Solution selon l'une quelconque des revendications 7 à 10, dans laquelle un solvant présentant le point d'ébullition le plus élevé constitue de 40 à 90 % en masse de la masse totale de solvant.

12. Solution selon l'une quelconque des revendications 7 à 11, dans laquelle la concentration d'un composé polymère dans la solution est de 0,5 à 2,0 % en masse.

13. Solution selon l'une quelconque des revendications 7 à 12, comprenant de plus un additif pour le contrôle de la viscosité et/ou de la tension superficielle.

14. Solution selon l'une quelconque des revendications 7 à 13, comprenant de plus un antioxydant.

15. Film émettant de la lumière comprenant un composé polymère selon l'une quelconque des revendications 1 à 5.

16. Film électro-conducteur comprenant un composé polymère selon l'une quelconque des revendications 1 à 5.

17. Film électro-conducteur selon la revendication 16, dans lequel la résistance de surface est de 1 kΩ/□ ou inférieure.

18. Film de semi-conducteur organique comprenant un composé polymère selon l'une quelconque des revendications 1 à 5.

19. Film de semi-conducteur organique selon la revendication 18, dans lequel la matière la plus importante de la mobilité des électrons ou de la mobilité des trous est de 10⁻⁵ cm²/V/s ou supérieure.

20. Transistor organique présentant un film de semiconducteur organique selon la revendication 18 ou 19.

21. Procédé de formation d'un film selon l'une quelconque des revendications 15 à 20 utilisant un procédé à jet d'encre.

22. Dispositif polymère émettant de la lumière présentant une couche comprenant un composé polymère selon l'une quelconque des revendications 1 à 5 entre des électrodes constituées d'une anode et d'une cathode.

23. Dispositif polymère émettant de la lumière selon la revendication 22, dans lequel la couche comprenant un composé polymère selon l'une quelconque des revendications 1 à 5 est une couche émettant de la lumière.

24. Dispositif polymère émettant de la lumière selon la revendication 23, dans lequel la couche émettant de la lumière comprend de plus un matériau de transport de trous, un matériau de transport d'électrons ou un matériau émettant de la lumière.

25. Source de lumière en feuille comprenant un dispositif polymère émettant de la lumière selon l'une quelconque des revendications 22 à 24.

26. Affichage à segment comprenant un dispositif polymère émettant de la lumière selon l'une quelconque des revendications 22 à 24.

27. Affichage à matrice de points comprenant un dispositif polymère émettant de la lumière selon l'une quelconque des revendications 22 à 24.

28. Affichage à cristaux liquides utilisant un dispositif polymère émettant de la lumière selon l'une quelconque des revendications 22 à 24 comme lumière arrière.
